## Europäisches Patentamt
## European Patent Office
## Office européen des brevets

(11) Numéro de publication: **0 002 087**
**B1**

(12)

# FASCICULE DE BREVET EUROPEEN

(45) Date de publication du fascicule de brevet: **05.08.81**

(21) Numéro de dépôt: **78200298.4**

(22) Date de dépôt: **13.11.78**

(51) Int. Cl.³: **H 01 L 27/08, H 01 L 21/82**
**//H03F3/26**

(54) **Dispositif semiconducteur monolithique comprenant deux transistors complémentaires et son procédé de fabrication.**

(30) Priorité: **14.11.77 FR 7734126**

(43) Date de publication de la demande:
**30.05.79 Bulletin 79/11**

(45) Mention de la délivrance du brevet:
**05.08.81 Bulletin 81/31**

(84) Etats Contractants Désignés:
**CH DE FR GB NL SE**

(56) Documents cités:
**FR - A - 2 138 904**
**FR - A - 2 216 677**
**FR - A - 2 216 678**
**US - A - 4 021 269**

(73) Titulaire: **R.T.C. LA RADIOTECHNIQUE-COMPELEC Société anonyme dite:**
**51 rue Carnot**
**F-92156 Suresnes (FR)**

(73) Titulaire: **N.V. Philips' Gloeilampenfabrieken**
**Pieter Zeemanstraat 6**
**NL-5621 CT Eindhoven (NL)**

(72) Inventeur: **Roger, Bernard**
**SPID - 209, rue de l'Université**
**F-75007 Paris (FR)**

(74) Mandataire: **Pinchon, Pierre et al,**
**Société Civile S.P.I.D. 209 rue de L'Université**
**F-75007 Paris (FR)**

Courier Press, Leamington Spa, England.

## Dispositif semiconducteur monolithique comprenant deux transistors complémentaires et son procédé de fabrication

La présente invention concerne un dispositif semiconducteur comportant un corps semiconducteur comprenant au moins un premier et un deuxième transistors verticaux, bipolaires et complémentaires, chaque transistor comprennent une région de base et deux régions externes faisant office de région d'émetteur et de région de collecteur, ledit corps étant constitué notamment d'un substrat recouvert d'une première couche épitaxiale d'un premier type de conductivité sur laquelle s'étend une deuxième couche épitaxiale du deuxième type de conductivité opposé au premier la région de base du premier transistor et au moins une partie d'une région externe du deuxième transistor étant formées par des portions coplanaires de la première couche épitaxiale, la région de base du deuxième transistor étant formée par une première portion de la deuxième couche épitaxiale, et une première portion du substrat constituant au moins une partie de la région de collecteur d'un desdits premier et deuxième transistors cependant qu'un barrage isolant s'étend depuis la face supérieure au moins jusqu'au substrat qui est contacté par une électrode sur sa face inférieure.

Un dispositif comme décrit ci-dessus, y compris le fait que le barrage isolant consiste principalement en une gorge qui s'enfonce à partir de la surface de la deuxième couche épitaxiale au moins jusqu'au substrat sont connus de la demande de brevet français no. 2 216 677.

Pour de nombreuses applications, notamment en amplification de puissance, on cherche à réaliser des dispositifs semiconducteurs monolithiques dans lesquels sont intégrés au moins deux éléments actifs complémentaires, par exemple deux transistors dont les régions correspondantes sont de types opposés; c'est le cas des montages amplificateurs dits Darlington mixtes comprenant un transistor, d'entrée ou de commande, par exemple de type PNP, dont le collecteur commande la base d'un transistor, de sortie ou de puissance, l'émetteur du transistor, d'entrée étant relié au collecteur du transistor de sortie. C'est le cas encore des montages amplificateurs dit push-pull, associant deux transistors complémentaires à propos desquels la demande de brevet déjà citée décrit une structure intégrée monolithique d'amplificateurs où les transistors sont chacun du genre "à base épitaxiale". Par cette expression, on entend que la région de base des transistors est constituée par un matériau semiconducteur relativement homogène, obtenu par épitaxie, contrairement au cas des transistors à base diffusée où la région de base est une zone à concentration inhomogène en impureté de dopage. On sait que les transistors à base épitaxiale présente une meilleure résistance aux phénomènes de second claquage.

Selon l'art antérieur cité, les deux transistors peuvent être intégrés dans une plaquette substrat en faisant appel aux techniques connues de dépôt épitaxique et de diffusion. Cependant un inconvénient résulte du fait que la base de l'un des deux transistors est obtenue à partir d'une deuxième couche épitaxiale, localisée au-dessus d'une première couche.

Dans une première forme de réalisation proposée de l'art antérieur, cette deuxième couche, localisée, constitue un îlot qui dépasse du niveau de la première couche ce qui conduit à une structure qui n'est plus planaire. Les opérations de gravure, par exemple pour les zones de contact, présentent certaines difficultés.

Dans une deuxième forme de réalisation proposée de l'art antérieur, la deuxième couche épitaxiale est localisée dans une zone dans laquelle l'épaisseur de la première couche épitaxiale a été réduite de sorte que les dénivellations finales sont atténuées mais dans ce cas les techniques à mettre en oeuvre présentent également des difficultés.

Un autre exemple relatif à une structure comparable à celle exposée en préambule a été décrite dans la demande de brevet français no. 2 297 495. Cette structure applicable principalement aux amplificateurs du type Darlington mixte, présente cependant les particularités que les transistors complémentaires sont constitués à partir de portions de deux couches épitaxiales superposées, de type opposé, ce qui permet alors d'obtenir une face active ayant une bonne planéité et facilite l'établissement des liaisons ohmiques superficielles, Ici, la gorge de séparation entre les transistors complémentaires ne s'enfonce pas jusqu'au substrat mais seulement jusqu'à la première des deux couches épitaxiales.

Une difficulté provient cependant du fait que, la liaison entre l'émetteur du transistor d'entrée et le collecteur du transistor de sortie de l'ensemble Darlington décrit dans cette demande de brevet nécessite une liaison métallique atteignant le fond d'une gorge de mésa. De plus, la liaison entre le collecteur du transistor d'entrée et la base du transistor de sortie est une liaison interne réalisée par la continuité entre ces deux régions dans une même couche épitaxiale, ce qui nécessite une couche enterrée localisée fortement dopée.

Un des buts de l'invention est d'améliorer les possibilités des dispositifs connus tels que les dispositifs amplificateurs mentionnés ci-dessus et de fournir pour les ensembles de deux transistors complémentaires une structure permettant des liaisons électriques plus simples, peu résistantes et fiables, tout en présentant néanmoins une surface active sensiblement plane.

L'invention concerne également un procédé de réalisation du dispositif, dont un mode de mise en oeuvre fait appel à la technique dite de thermomigration. En ce domaine, le fait de créer, par thermomigration d'une impureté dans un substrat semiconducteur des portions de substrat de types de conductivité différents, lesdites portions formant des jonctions P/N, le fait que le substrat soit du silicium de type N et que l'impureté soit de l'aluminium sont, par ailleurs, connus du brevet des Etats-Unis d'Amérique numéro 4 021 269.

Aussi, un dispositif semiconducteur comme défini dans le préambule et conforme à la présente invention, se caractérise en ce que au moins une partie d'une région externe du premier transistor est formée par une seconde portion de la deuxième couche épitaxiale, coplanaire de la première portion de ladite couche, en ce que au moins une partie de la région d'émetteur d'un transistor est constituée par une deuxième portion du substrat contiguë à et coplanaire avec la première portion du substrat et de type de conductivité opposé à celle-ci, les deux portions du substrat formant une jonction P/N, en ce que ladite jonction P/N constitue au moins une partie d'une jonction P/N qui s'étend depuis la face inférieure du substrat jusqu'audit barrage isolant, les première et deuxième portions du substrat étant contactées par ladite électrode sur la face inférieure dudit substrat.

Dans le dispositif selon la présente invention, les connexions des transistors de l'ensemble complémentaire sont réalisées par des couches conductrices déposées sur les surfaces du dispositif; elles peuvent donc être d'une résistance aussi basse qu'on peut le désirer.

Une liaison électrique entre les deux régions externes créées dans des portions contiguës de substrat (l'émetteur de l'un des transistors et le collecteur de l'autre) est obtenue très simplement au moyen d'une électrode conductrice, metallique par exemple, s'étendant sur la face inférieure du substrat.

La face supérieure (ou face active) du dispositif qui est la face supérieure de la deuxième couche épitaxiale se présente également avec une bonne planéité qui permet d'y aménager des liaisons électriques de bonne qualité, par exemple au moyen de dépôts métalliques localisés. Du fait des surfaces planes, les connexions sont fiables. Elles sont faciles à réaliser. De plus, leur dépôt à la fin de la fabrication n'entraîne aucune perturbation dans le dispositif.

Dans une première disposition de l'ensemble des transistors complémentaires selon l'invention, les régions réalisées dans le substrat sont l'émetteur du "premier transistor" et une première zone de collecteur du "deuxième transistor", tandis que la base du "premier transistor" et une deuxième zone du collecteur du "deuxième transistor" sont constitués par des portions de la première couche épitaxiale et que le collecteur du "premier transistor" et la base du "deuxième transistor" sont constitués par des portions de la deuxième couche épitaxiale, l'émetteur du "deuxième transistor" étant constitué par une zone dopée du premier type de conductivité, incluse dans la deuxième couche épitaxiale, le contact de base du "premier transistor" étant constitué d'une zone dopée du premier type de conductivité qui s'étend depuis la face supérieure jusqu'à une profondeur supérieure à celle de la deuxième couche épitaxiale. Des régions de contact de collecteur du "premier transistor" et de contact de base du "deuxième transistor" sont constituées éventuellement par des zones dopées du deuxième type de conductivité créées dans la deuxième couche épitaxiale. Ces régions sont constituées généralement de zones diffusées ou implantées. Dans cette disposition le collecteur du "premier transistor" (celui dont la base faite dans la première couche épitaxiale est du premier type de conductivité) peut être connecté facilement à la base du "deuxième transistor" (celui dont la base est faite dans la deuxième couche épitaxiale du deuxième type de conductivité). Il s'ensuit que l'invention dans cette disposition est directement applicable à l'obtention d'une montage Darlington mixte d'un premier type donné.

En effet, dans l'application de cette première disposition à un montage Darlington mixte, le transistor d'entrée de l'amplificateur est le "premier transistor" et le transistor de sortie est le "deuxième transistor", le collecteur du "premier transistor" étant relié à la base du "deuxième transistor", une électrode connectée à la base du "premier transistor" constituant l'entrée de l'amplificateur et les deux régions créées dans le substrat étant court-circuitées par l'électrode s'étendant sur la face inférieure du substrat et constituant la sortie.

Dans une deuxième disposition de l'ensemble des transistors complémentaires selon l'invention, le collecteur du "premier transistor" et une première zone de l'émetteur du "deuxième transistor" sont les régions réalisées dans le substrat tandis que la base du "premier transistor" et une deuxième zone de l'émetteur du "deuxième transistor" sont constituées par des portions de la première couche épitaxiale, et que l'émetteur du "premier transistor" et la base du "deuxième transistor" sont constitués par des portions de la deuxième couche épitaxiale, la région de collecteur du "deuxième transistor" étant constituée par une zone dopée du premier type de conductivité incluse dans ladite deuxième couche épitaxiale et une région de contact de base du "premier transistor" étant constituée d'une zone du premier type de conductivité de préférence fortement dopée qui s'étend depuis la face supérieure jusqu'à une profondeur supérieure à l'épaisseur de la deuxième couche épitaxiale. Une région de contact de base du "deuxième transistor" et une région de contact d'émetteur du "premier transistor" sont constituées par des zones dopées du deuxième type de conductivité créées dans la deuxième couche épitaxiale. Ces zones peuvent également être diffusées ou implantées.

Dans cette deuxième disposition de l'ensemble complémentaire, c'est le "deuxième transistor" (celui dont la base, faite dans la deuxième couche épitaxiale, est du deuxième type de conductivité) dont le collecteur peut être connecté facilement à la base du transistor complémentaire, en l'occurrence le "premier transistor" (celui dont la base est faite dans la première couche épitaxiale du premier type de conductivité) et notamment servir ainsi de transistor d'entrée à un montage Darlington mixte dont le transistor de sortie est le "premier transistor".

Dans l'application de cette deuxième disposition à un montage Darlington mixte, le transistor d'entrée de l'amplificateur est le "deuxième transistor" et le transistor de sortie est le "premier transistor", le collecteur du "deuxième transistor" étant relié à base du "premier transistor", une électrode connectée à la base dudit "deuxième transistor" constituant l'entrée de l'amplificateur et les deux régions créées dans le substrat étant court-circuitées par l'électrode s'étendant sur la face inférieure du substrat et constituant la sortie.

Il est clair que un montage Darlington ayant la "deuxième disposition" réalisé sur la même plaquette qu'un montage Darlington ayant la "première disposition" est du type opposé et complémentaire au type de celui-ci.

On peut donc, sur une même plaquette, obtenir des ensembles de types opposés et complémentaires de deux transistors complémentaires et notamment des montages Darlington mixtes NPN/PNP et PNP/NPN.

Dans une forme avantageuse de réalisation de dispositifs amplificateurs, deux ensembles complémentaires, de transistors complémentaires, l'un ayant la première disposition, l'autre la deuxième disposition, constituant chacun un montage Darlington mixte, sont combinés sur une même plaquette pour constituer un amplificateur du type dit "push-pull" symétrique.

Ce dispositif comportant dans une même corps semiconducteur un premier montage Darlington mixte constitué par un premier ensemble ayant la "première disposition" et un deuxième montage Darlington mixte constitué par un second ensemble ayant la "deuxième disposition" est notamment caractérisé en ce que les deux portions de substrat, les deux portions de première couche épitaxiale et les deux portions de deuxième couche épitaxiale utilisées pour le premier ensemble sont respectivement coplanaires aux deux portions de substrat, aux deux portions de première couche épitaxiale et aux deux portions de deuxième couche épitaxiale utilisées pour le deuxième ensemble, en ce que les régions des transistors du premier ensemble créées dans les deux dites couches épitaxiales sont séparées des regions des transistors du deuxième ensemble créées dans les deux dites couches par un barrage isolant s'étendant depuis la face supérieure jusqu'à une profondeur supérieure à l'épaisseur des deux dites couches épitaxiales, en ce que les dites quatre portions de substrat sont court-circuitées par l'électrode conductrice reposant sur la face inférieure du substrat et en ce que ces deux montages Darlington constituent un amplificateur de type dit "push-pull" dont les entrées sont la base du "premier transistor" du premier ensemble et la base du "deuxième transistor" dudit deuxième ensemble et dont la sortie est l'électrode située sur la face inférieure du substrat.

Les aventages de ce dispositif sont nombreux. Il possède d'abord les avantages des Darlington qui le composent: faible résistance des connexions, fiabilité, facilité de réalisation. De plus, il est en particulier intéressant en ce qu'il permet de mettre l'électrode métallique placée sur la face inférieure du substrat au zéro de la haute tension, ce qui est commode; cette électrode est reliée au dissipateur et à l'enveloppe et l'usager ne peut toucher la haute tension, ce qui améliore la sécurité. Par ailleurs, tout le dispositif étant à la même température, il n'y a pas besoin d'une circuiterie supplémentaire pour améliorer la stabilité en température, ce qui est nécessaire sur des éléments discrets.

Les différentes zones et régions des dispositifs selon l'invention sont faites de matériau dopé selon les nécessités. Il va de soi que les émetteurs, les zones de contact ou de conduction sont de préférence fortement dopées, tandis que les bases et collecteurs comportent des zones faiblement dopées, de façon à obtenir les meilleures caractéristiques, en particulier les tensions de claquage voulues pour le dispositif.

La liaison électrique entre l'émetteur du "premier transistor" et le collecteur du "deuxième transistor" dans la première disposition, et la liaison électrique entre l'émetteur du "deuxième transistor" et le collecteur du "premier transistor" dans la deuxième disposition (émetteur du transistor d'entrée et collecteur du transistor de sortie dans les deux cas d'application au montage Darlington mixte) obtenues très simplement, par exemple, au moyen d'une électrode métallique s'étendant sur la face inférieure du substrat, est réalisée notamment lorsque, par soudure, le substrat est rendu solidaire d'un support métallique servant en même temps de dissipateur thermique. La liaison ainsi réalisée est peu résistante et très fiable.

Le barrage isolant séparant, notamment dans une application à un montage Darlington, d'une part, la base du "premier transistor" au niveau de la première couche, et d'autre part la base du "deuxième transistor" d'une région externe du "premier transistor" au niveau de la deuxième couche, et le barrage séparant, dans l'application à un amplificateur dit "push-pull" à deux montages Darlington complémentaires, le premier montage Darlington du deuxième montage Darlington, sont avantageusement constitués par des gorges qui s'enfoncent depuis la surface de la deuxième couche épitaxiale jusque dans le substrat et qui peuvent être remplies d'un matériau isolant ou seulement recouvertes d'un matériau isolant de passivation, par exemple d'un oxyde.

Un tel barrage isolant pourrait également être réalisé par oxydation localisée et, éventuellement, au moyen d'une implantation d'ions azote par exemple.

Si la création du barrage isolant entraîne sur la face active un défaut de planéité, on peut ménager pour le franchissement de cette dénivellation par des pellicules conductrices de connexion qui font la liaison entre une électrode du "premier transistor" et une électrode du "deuxième transistor" une aire plane ou plus plane en créant dans ce barrage une interruption ou une discontinuité qui forme passage.

Si le barrage est obtenu à partir d'une gorge, il suffit de laisser la plaquette plane à l'endroit où l'on désire créer cette connexion; ledit passage est constitué par le matériau semiconducteur ainsi laissé en place.

Les avantages de fiabilité que donne à un chemin de conduction le fait que la couche qui le réalise soit plane, font de l'interruption du barrage une solution que l'on peut considérer comme préférentielle.

Dans une première configuration, le fond contigu au substrat d'au moins une partie dudit barrage isolant est bordé d'une côté par une portion du substrat du premier type de conductivité et, de l'autre côté, par une portion du substrat du deuxième type de conductivité et ladite jonction P/N située entre ces deux portions contiguës du substrat aboutit directement audit barrage isolant.

Dans une deuxième configuration, le barrage isolant séparant dans la première couche épitaxiale du premier type de conductivité une première portion constituant la base d'un transistor d'un premier type, d'une deuxième portion constituant une zone d'une région externe d'un transistor complémentaire au premier, touche ledit substrat uniquement dans la portion de celui-ci qui est du deuxième type de conductivité, et ladite portion du substrat débordant ledit barrage constitue avec l'extrémité voisine de ladite deuxième portion de première couche épitaxiale une jonction P/N. Cette jonction qui aboutit à une de ses extrémités audit barrage isolant rejoint, à l'autre extrémité, la jonction P/N située entre les deux portions de types opposés du substrat avec laquelle elle constitue une jonction P/N s'étendant de la face inférieure du substrat jusqu'au dit barrage isolant.

Cette double possibilité donne à la réalisation une grande souplesse car elle permet une grande tolérance de fabrication.

Le procédé de réalisation d'un dispositif selon l'invention fait appel à des techniques connues. Ce procédé est remarquable en ce qu'il comporte notamment les opérations suivantes:

—dans une plaquette de bonne qualité cristalline d'un type initial de conductivité, des impuretés donnant le type de conductivité opposé au précédent sont introduites localement, au moins sur une certaine épaisseur de substrat, avec une concentration supérieure à celle de ladite plaquette, pour créer, dans celle-ci, au moins une portion du type de conductivité opposé au type initial, puis la première couche épitaxiale faiblement dopée est déposée sur l'une des grandes faces de ladite plaquette, sur laquelle affleurent des portions des deux types de conductivité, puis la deuxième couche épitaxiale faiblement dopée du type de conductivité opposé à celui de ladite première couche épitaxiale est déposée sur celle-ci; ensuite, des régions localisées sont créées dont au moins deux du type de conductivité de la première couche épitaxiale, l'une d'une profondeur supérieure à l'épaisseur de la deuxième couche épitaxiale étant destinée à constituer le contact de base du "premier transistor", l'autre, destinée à créer une zone externe du "deuxième transistor", étant incluse dans la deuxième couche épitaxiale, le barrage isolant est élaboré, et les contacts et les connexions sont créés.

La réalisation du dispositif qui fait appel principalement à des techniques connues comporte donc peu d'aléas.

Lors de l'introduction dans la plaquette substrat d'impuretés destinées à créer dans celle-ci des portions du type de conductivité opposé au type initial, lesdites impuretés peuvent être introduites dans toute l'épaisseur de la plaquette dont l'ensemble constitue alors le substrat, ce qui est particulièrement simple.

On peut également limiter la profondeur des impuretés que l'on introduit à partir de l'une des faces de ladite plaquette à une valeur inférieure à l'épaisseur de celle-ci, laissant, du côté de la face opposée à la face d'introduction, une couche du type initial de conductivité, qu'ultérieurement on élimine. Ceci permet de diminuer le temps d'introduction des impuretés et simultanément de disposer, au cours des manipulations, d'une plaquette épaisse et résistante.

Selon un premier mode de mise en oeuvre du procédé, l'introduction, localisée et à forte concentration, d'impuretés donnant le type de conductivité opposé à au moins une portion d'une plaquette du type initial de conductivité, est effectuée par déplacement d'une zone en fusion dans un gradient de température, opération souvent désignée sous le terme de thermomigration.

La plaquette étant en silicium et présentant le type de conductivité N ou $N^+$ (le signe + indiquant un fort dopage), des parties de substrat fortement dopées de type $P^+$ sont obtenues par thermomigration d'aluminium.

On pourrait également partir d'un substrat de type P$^+$ et y réaliser des zones N$^+$ notamment par thermomigration d'or-antimoine.

La mise en oeuvre par thermomigration est rapide, elle comporte peu d'opérations, elle est donc économique.

Selon un deuxième mode de mise en oeuvre du procédé, l'introduction, localisée et à forte concentration, d'impuretés donnant le type de conductivité opposé à au moins une portion d'une plaquette d'un type initial de conductivité est effectuée par diffusion, par exemple à partir d'un dépôt de prédiffusion.

On peut, par exemple, obtenir des portions P$^+$ dans une plaquette de silicium de type N$^+$ par diffusion d'aluminium ou de bore, ou obtenir des portions de type N$^+$ dans une plaquette de silicium de type P$^+$ en diffusant du phosphore.

Ce mode de mise en oeuvre utilise des procédés particulièrement connus. Il est donc immédiatement réalisable.

L'invention est applicable en particulier à la réalisation de dispositifs à transistors complémentaires, du type Darlington mixte, destinés notamment à des amplificateurs. Des agencements de deux ensembles de transistors complémentaires montés chacun en Darlington mixte et formant un amplificateur "push-pull" sont avantageusement réalisés avec la structure selon l'invention dans une plaquette monolithique.

La description qui va suivre, en regard des dessins annexés, fera bien comprendre comment l'invention peut être réalisée.

La figure 1 est un schéma d'un montage Darlington mixte à deux transistors comple-méntaires.

La figure 2 est un schéma d'un amplificateur dit "push-pull" comportant deux montages complémentaires à deux transistors complémentaires.

La figure 3 est une coupe schématique suivant la ligne III III de la figure 4, d'un ensemble de deux transistors complémentaires ayant la première disposition et la première configuration.

La figure 4 est une vue en plan du dispositif de la figure 3.

La figure 5 est une deuxième coupe schématique du dispositif des figures 3 et 4 suivant la ligne V V de la figure 4 montrant notamment une interruption dans le barrage isolant.

La figure 6 est une vue en plan d'une deuxième topologie d'un ensemble à deux transistors complémentaires ayant également la première disposition et la première configuration.

La figure 7 est une coupe schématique, suivant la ligne VII VII, du dispositif de la figure 6.

La figure 8 est une coupe schématique, suivant la ligne VIII VIII de la figure 9, d'un ensemble de deux transistors complémentaires ayant la deuxième disposition et la deuxième configuration.

La figure 9 est une vue en plan du dispositif de la figure 8.

La figure 10 est une coupe schématique d'un amplificateur dit "push-pull" comportant deux ensembles complémentaires à deux transistors complémentaires.

La figure 11 comportant 9 schémas, repérés 11A à 11I, illustre en coupe les différentes étapes de l'élaboration du dispositif de la figure 10 selon le premier mode de mise en oeuvre du procédé de l'invention.

La figure 12 comportant 8 schémas, repérés 12A à 12H, représente en coupe les différentes étapes, selon un deuxième mode de mise en oeuvre du procédé de l'invention, de l'élaboration d'un amplificateur dit "push-pull" symétrique d'une topologie légèrement différente.

Il est à noter que, pour rendre les dessins plus clairs, les proportions ne sont pas respectées notamment en ce qui concerne les épaisseurs de couches.

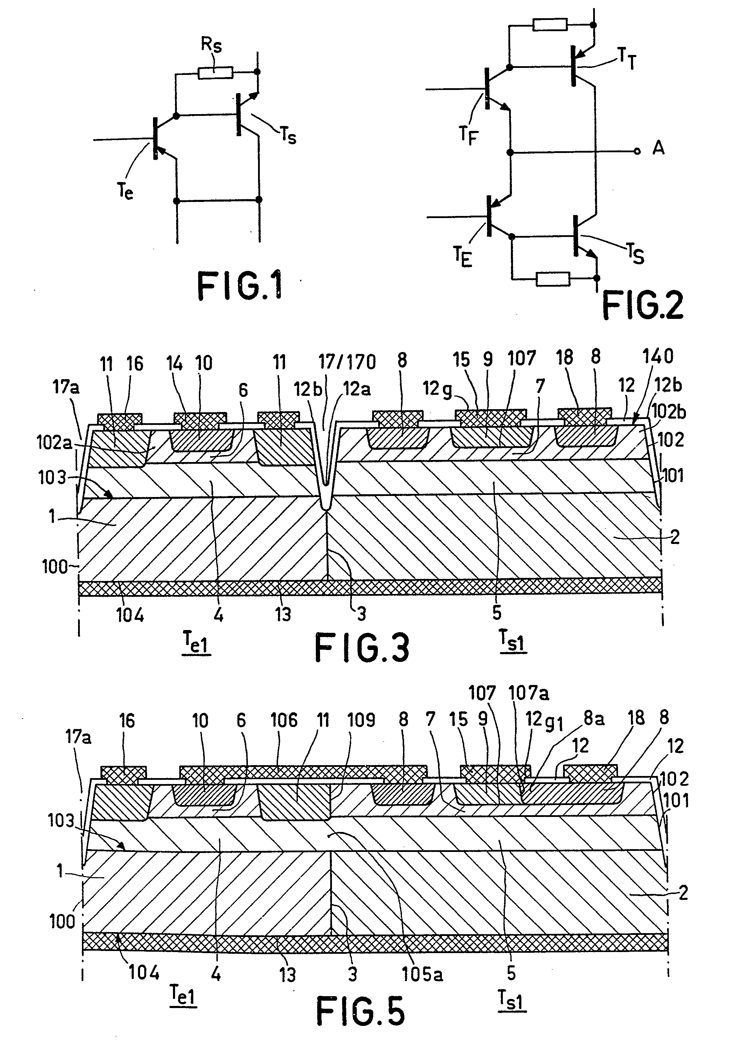

Les circuits des figures 1 et 2 sont des exemples de circuits qui peuvent être réalisés dans un dispositif selon l'invention.

Le circuit de la figure 1 est celui d'un montage amplificateur "Darlington mixte" comprenant deux transistors complémentaires: un transistor d'entrée $T_e$ et un transistor de sortie $T_s$. Sur la figure, le transistor d'entrée est un PNP et le transistor de sortie un NPN. Le schéma d'amplificateur Darlington mixte dont le transistor d'entrée est un NPN et le transistor de sortie un PNP (complémentaire du précédent ou de type opposé) est également possible. Ce type de circuit comporte également une résistance $R_s$ ajoutée en parallèle sur la jonction base-émetteur du transistor de sortie pour améliorer les caractéristiques de transfert. En effet, cette résistance dérive une partie du courant de fuite du transistor d'entrée qui, de ce fait, n'est pas amplifié dans le transistor de sortie.

Le circuit de la figure 2 est celui d'un amplificateur de type dit "push-pull" symétrique comprenant deux montages "Darlington mixte" complémentaires. Un premier "Darlington mixte" est un PNP/NPN composé des transistors d'entrée et de sortie $T_E$ et $T_S$ et le deuxième montage "Darlington mixte" complémentaire du premier est un NPN/PNP composé des transistors d'entrée et de sortie $T_F$ et $T_T$.

Comme le précédent, ce circuit peut être intégré dans une plaquette monolithique dans une des formes de réalisation de la présente invention.

Les figures 3, 4 et 5 représentent un dispositif semiconducteur ayant la première configuration et la première disposition et comportant un corps semiconducteur comprenant au moins un "premier transistor" $T_{el}$ et un "deuxième transistor" $T_{sl}$ les dits transistors étant verticaux, bipolaires et complémentaires.

Le dit corps est constitué notamment d'un substrat plan référencé 100 recouvert sur sa face 103 d'une première couche épitaxiale 101 d'un premier type de conductivité sur laquelle s'étend une deuxième couche épitaxiale 102 du deuxième type de conductivité opposé au premier; la région de base 4 du "premier transistor" $T_{el}$ et une partie du collecteur 5 du "deuxième transistor" $T_{sl}$ sont formées de deux portions coplanaires de la première couche épitaxiale. La région de base 7 du "deuxième transistor" et le collecteur 6 du "premier transistor" sont formés de portions coplanaires de la deuxième couche épitaxiale. La portion 2 (du premier type de conductivité) du substrat qui constitue une autre partie de la région de collecteur du "deuxième transistor" est contiguë à la portion 1 du deuxième type de conductivité du dit substrat qui constitue l'émetteur du "premier transistor".

Ces deux portions 1 et 2 du substrat 100 sont séparées par une jonction 3 qui, du fait que le dispositif des figures 3, 4 et 5 a la première configuration, s'étend de la face inférieure 104 du substrat jusqu'au fond d'un barrage isolant 170 qui s'enfonce à partir de la face 140 supérieure et active du dispositif à travers les couches 102 et 101 et la surface 103 du substrat jusqu'à l'intérieur de celui-ci.

L'émetteur 9 du "deuxième transistor" est constitué par une zone dopée du premier type de conductivité incluse dans la deuxième couche épitaxiale et le contact de base 11 du "premier transistor" est constitué par une zone dopée du même premier type de conductivité s'étendant depuis la face supérieure 140 jusqu'à une profondeur supérieure à celle de la deuxième couche épitaxiale.

Pour ce premier exemple, le "premier transistor" $T_{el}$ est un PNP et le "deuxième transistor" $T_{sl}$ est un NPN, la portion 1 du substrat étant du type P dopé à l'aluminium avec une concentration de $5.10^{19}$ atomes/cm³ et la portion 2 étant du type N dopée à l'antimoine à une concentration de $5.10^{18}$ atomes/cm³.

La première couche épitaxiale 101 est de type de conductivité N comme la portion de substrat 2 mais peu dopée (par exemple $10^{15}$ atomes/cm³) donnant une résistivité de 3 Ω cm.

La deuxième couche épitaxiale 102 est de type P peu dopée (par exemple $3.10^{15}$ atomes/cm³).

La gorge isolante 17 sépare dans la couche 101 la base 4 du "premier transistor" du collecteur 5 du "deuxième transistor" et dans la couche 102 les portions $102_a$ dont la plus grande partie constitue le collecteur 6 du "premier transistor" et une portion $102_b$ dont la plus grande partie constitue la base 7 du "deuxième transistor".

Sur la figure 3 le fond de ladite gorge 17 est bordé d'un côté par la portion 1 du substrat et de l'autre par la portion 2 du même substrat, la jonction 3 s'étendant directement selon la "première configuration" de la face inférieure 104 du substrat opposée à la face 103 jusqu'au fond de ladite gorge 17.

Cette gorge 17 comporte une interruption 105 formant passage supportant une couche métallique plane 106 de connexion d'un transistor à l'autre.

Sur ces figures 3, 4 et 5 on a repéré par $17_a$ les mésas créés sur les bords de ce circuit intégré en même temps que la gorge isolante 17.

Une zone 10, peu profonde, très dopée de type $P^+$, diffusée dans la portion $102_a$, sert à diminuer la résistance du collecteur 6 du "premier transistor". Une zone 11, très dopée de type $N^+$, est diffusée également dans la portion $102_a$ et, à travers elle, à une profondeur suffisante pour qu'elle atteigne la base 4 du "premier transistor" et qu'elle assure la prise de contact sur celle-ci. On donne de préférence à cette zone une forme d'anneau, de couronne, de tore ou de ceinture et, plus généralement d'un volume homéomorphe à ces volumes, entourant le collecteur 6. Il est rappelé qu'en topologie deux figures sont homéomorphes lorsque chacune peut être la transformée de l'autre par déformation continue comme cela est dit par exemple dans le livre intitulé Topology de E. M. PATTERSON page 2, notamment lignes 9 à 16.

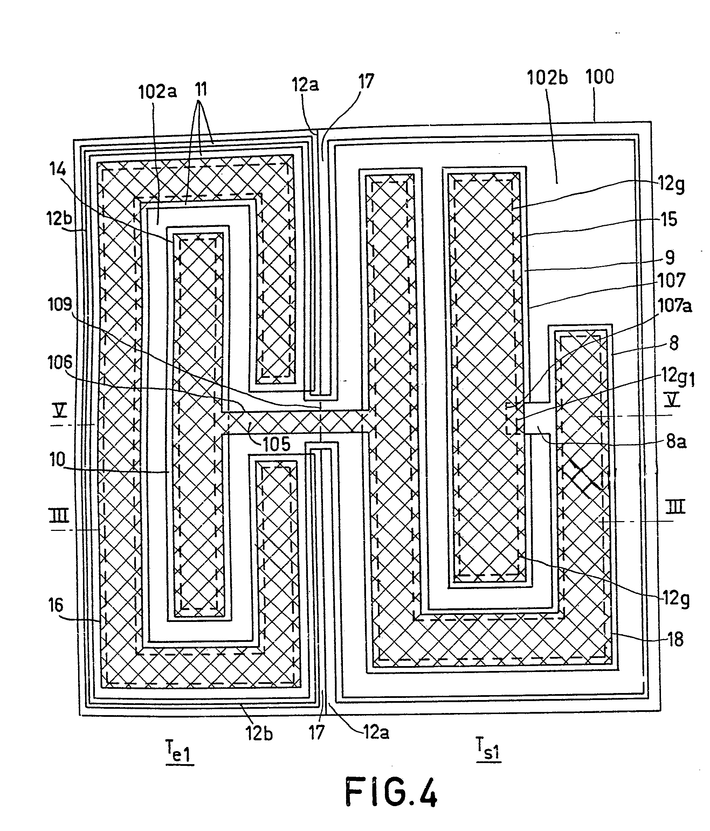

Une zone 9 peu profonde très dopée de type $N^+$ diffusée dans la portion $102_b$ constitue l'émetteur du "deuxième transistor". Une zone 8 peu profonde très dopée de type $P^+$, diffusée également dans la portion $102_b$, sert à améliorer la prise de contact sur la base 7 du "deuxième transistor". Avantageusement on donne à cette zone la forme d'un crochet qui entoure partiellement l'émetteur du "deuxième transistor", et on crée sur ce crochet une protubérance $8_a$ qui sert à réaliser la résistance $R_{sl}$ comme il est expliqué plus loin. La jonction émetteur base du "deuxième transistor" est représentée par la ligne continue 107 sur la figure 4.

La surface du dispositif est recouverte d'une couche 12 d'oxyde isolant dans laquelle sont percées des ouvertures de contact. On a désigné par $12_a$ le pli de l'oxyde au fond de la gorge d'isolement 17, par $12_b$ les arêtes d'oxyde situées au bord de la gorge d'isolement et au bord des mésas et par $12_g$ les bords de la couche d'oxyde le long de l'ouverture de contact d'émetteur du "deuxième transistor". Ces contours sont représentés figure 4.

Les contacts sont pris au moyen de pellicules métalliques en 16 pour la base et en 14 pour le collecteur du "premier transistor", en 18 pour la base et en 15 pour l'émetteur du "deuxième transistor".

Il est à remarquer sur la figure 4 que, bien que la zone 11 ait une forme fermée homéomorphe à un anneau, ce n'est pas le cas de la pellicule 16 qui comporte une ouverture pour laisser le passage à la pellicule conductrice 106 qui connecte le contact de collecteur 14 du "premier transistor" au contact de base 18 du "deuxième transistor" contact qui a la forme en crochet de la zone 8.

Un dépôt métallique 13 sur la face inférieure 104 du substrat 100 assure un court-circuit de la jonction 3 entre les portions 1 et 2 dudit substrat et en même temps assure le contact sur l'émetteur du "premier transistor" et sur le collecteur du "deuxième transistor". Le dépôt13 constitue une liaison électrique fiable, de résistance minimale.

La gorge 17 est interrompue par un passage 105. Au niveau de la première couche épitaxiale 101, cette interruption laisse une zone de liaison $105_a$ entre les portions 4 et 5 de la couche 101. Le dispositif décrit dans cet exemple ayant la première disposition, la portion 4 est la base du "premier transistor" et la portion 5 est une partie du collecteur du "deuxième transistor" relié à l'émetteur 1 du "premier transistor"; cette zone de liaison constitue donc une résistance en parallèle sur la jonction émetteur-base du "premier transistor". Dans le cas de l'application au montage Darlington elle dérive une partie du courant de commande du transistor d'entrée issu des étages précédents; de ce fait, sa présence diminue le gain du transistor d'entrée.

Toutefois, ceci n'est pas toujours un inconvénient; dans un emploi en basse fréquence par exemple, on met à l'entrée une résistance qui écrase les petits signaux pour éviter d'amplifier le bruit; de plus cette résistance réagit sur le transistor qui précède, et on peut, en fixant sa valeur de manière adéquate, fixer le mode et la plage de fonctionnement de ce transistor. Dans tous ces cas, sa présence est utile, on a parfois intérêt à ce qu'elle air la valeur la plus faible possible compatible avec le gain de l'ensemble des transistors et, dans la mesure où on connait le circuit précédent, on peut l'intégrer.

Le choix de la première disposition de l'invention est particulièrement intéressant en ce que la résistance du passage est parfois bénéfique.

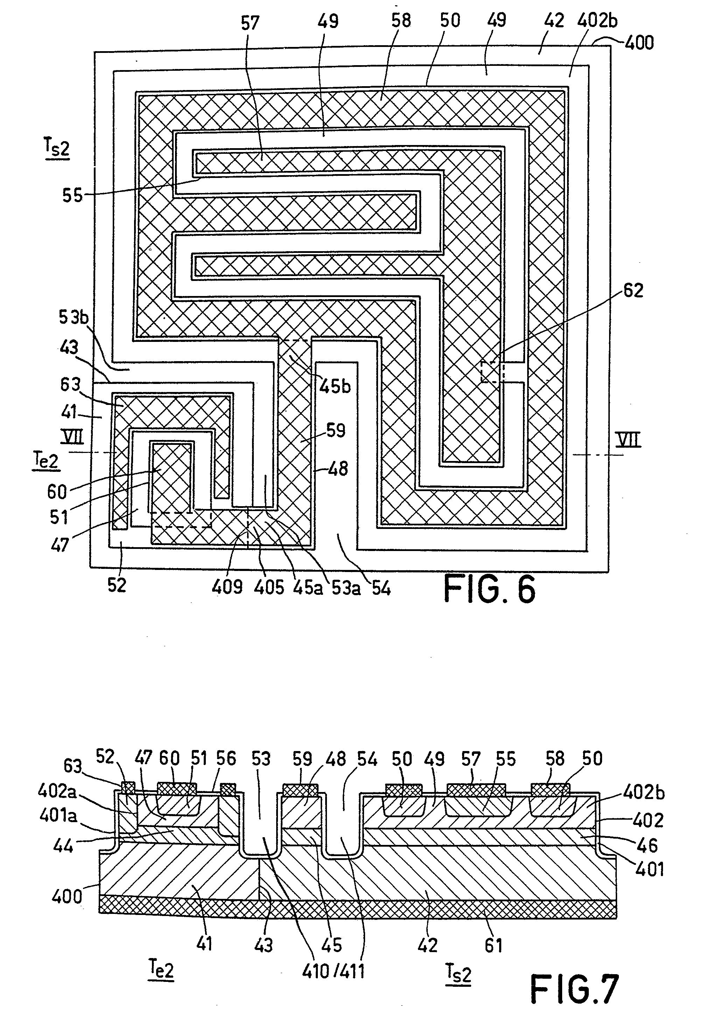

Comme la première couche épitaxiale a été peu dopée (sa résistivité est par exemple de 3 $\Omega$ cm) cette zone de liaison est déjà assez résistante pour que le gain du transistor en soit peu affecté et, pour autant que cette résistance constitue une résistance parasite, on peut lui donner une valeur élevée, par exemple pour améliorer des performances en commutation. Cette valeur élevée peut être obtenue par exemple en donnant à ladite zone de liaison une forme allongée ou, plus exactement, en faisant suivre cette zone de liaison d'un ou de plusieurs segments allongés qui constituent, en fait, des résistances séries. On utilise avantageusement dans ce but la topologie décrite en détail dans l'exemple suivant au regard des figures 6 et 7. On peut également, pour augmenter cette résistance, remplacer l'interruption par une discontinuité notamment en diminuant la profondeur de la gorge ce qui constitue une solution de compromis.

Au niveau de la deuxième couche épitaxiale 102, la base 7 du second transistor $T_{sl}$ et le collecteur 6 du premier transistor $T_{el}$ sont isolés par le contact de base 11 du premier transistor $T_{el}$, contact dont la forme est homéomorphe à celle d'un anneau et par la jonction 109.

La couche d'oxyde 12 recouvre ce passage 105 qui supporte la connexion 106 mentionneé ci-dessus.

Comme il a été dit ci-dessus la zone 8 de contact de base du transistor $T_{sl}$ (dont le contour exact à l'intérieur de la zone de base 7 n'est pas représenté sur la figure) présente une protubérance $8_a$, qui s'étend sous la plage 120 de la couche 12 et au-delà du bord $12_{gl}$ de cette plage directement sous la pellicule métallique 15. La jonction base émetteur 107 du deuxième transistor présente donc un détour $107_a$, dans lequel elle supporte directement la pellicule métallique 15. Ainsi est créée la résistance $R_{sl}$ en parallèle sur la jonction émetteur-base du transistor $T_{sl}$. Cette résistance sépare le courant de fuite des deux transistors, elle dérive le courant de fuite du transistor d'entrée et évite que ce courant ne soit amplifié par le transistor de sortie. La géométrie de cette résistance n'est donnée sur les figures qu'à titre indicatif. On peut l'adapter à la résistivité de la couche.

On dispose ainsi d'un montage Darlington mixte particulièrement fiable conforme au schéma de la figure 1 dont le transistor d'entrée $T_{el}$ a un émetteur 1, une base 4, un collecteur 6, une zone de contact de base 11, une zone de contact de collecteur 10 et dont le transistor de puissance $T_{sl}$ a un collecteur 5 et une zone de conduction de collecteur 2, une base 7 et une zone de contact de base 8 et enfin un émetteur 9. Une résistance en parallèle sur la jonction émetteur-base du transistor d'entrée $T_{el}$ est constituée par la partie $105_a$ du passage 105 qui traverse la gorge 17 et la résistance $R_{sl}$ en parallèle sur la jonction émetteur-base du transistor de sortie $T_{sl}$ est constituée par les couches superficielles de la protubérance $8_a$ de la zone de contact de base qui amène la partie $107_a$ de la jonction 107 directement sous le contact d'émetteur 15.

La connexion qui relie le collecteur de $T_{el}$ à la base de $T_{sl}$ est constituée par la pellicule 106. La connexion qui relie l'émetteur de $T_{el}$ au collecteur de $T_{sl}$ est constituée par la couche 13. Ces connexions sont peu résistives, fiables et faciles à réaliser.

Ce dispositif Darlington mixte peut être réalisé dans une topologie voisine représentee figures 6 et 7 sur lesquelles le transistor d'entrée est référencé $T_{e2}$ et le transistor de sortie $T_{s2}$. Sur ces figures on a repéré en 41 et 42 les portions coplanaires du substrat 400 qui constituent la jonction 43. La portion 41 de plus petite surface est de type $P^+$; elle constitue l'émetteur du transistor d'entrée $T_{e2}$, "premier transistor". La portion 42 est du type $N^+$ et constitue une partie du collecteur du transistor de sortie $T_{s2}$, "deuxième transistor".

Les deux portions de substrat sont recouvertes d'une couche épitaxiale 401 faiblement dopée de type N, elle-même recouverte d'une deuxième couche 402 épitaxiale faiblement dopée de type P.

Les deux couches épitaxiales superposées sont l'une et l'autre partagées par un barrage isolant 53 constitué à partir d'une gorge 410 creusée jusqu'au substrat dans lequel elle pénètre légèrement et qui comporte deux tronçons 53$_a$ et 53$_b$ perpendiculaires l'un à l'autre et un barrage additionnel 54.

La jonction 43 suit, sur sa plus grande longueur, le tracé des tronçons 53$_a$ et 53$_b$, la portion 41 du substrat étant sousjacente à la portion 401$_a$ de la couche 401 qui constitue la base 44 du transistor T$_{e2}$. La portion 41 est sous-jacente également à la portion 402$_a$ de la couche 402 dans laquelle sont diffusées d'une part une zone homéomorphe à un anneau 52 fortement dopée de type N$^+$ atteignant la portion de couche sous-jacente 44 et constituant le contact de base et d'autre part la zone 51 fortement dopée de type P$^+$, moins profonde que la couche elle-même, et qui, avec la partie restante 47 de la portion 402$_a$, constitue le collecteur du transistor d'entrée T$_{e2}$.

La portion de la première couche épitaxiale 401 située du côté du tronçon 53$_a$ du barrage isolant opposé à celui dans lequel est créé le "premier transistor" comporte elle-même 2 portions: en premier lieu, la portion 46 qui s'étend sur une grande partie de la portion 42 du substrat avec laquelle elle constitue le collecteur du transistor de sortie T$_{s2}$; par ailleurs on a, au moyen d'un barrage isolant additionnel 54 constitué à partir d'une gorge 411 sensiblement parallèle au tronçon 53$_a$ séparé une portion 45 en forme de segment étroit, allongé entre les deux dits barrages isolants 53$_a$ et 54.

Ce segment 45 est relié par une première extrémité 45$_a$ via la zone de liaison du passage 405 à la base 44 du "premier transistor" et par sa deuxième extrémité 45$_b$ à la zone 46 de la région externe du "deuxième transistor" T$_{s2}$ créée dans ladite première couche épitaxiale 401, c'est-à-dire dans cet exemple au collecteur du "deuxième transistor". Il constitue une résistance mise en série avec la résistance parasite en parallèle sur la jonction émetteur base du transistor d'entrée. On peut ainsi donner à cette résistance une valeur élevée, 10 kΩ par exemple.

Un avantage de cette topologie réside précisément dans la valeur élevée que cette forme allongée donne à la résistance R$_{e2}$.

Le tronçon de barrage isolant 54 sépare également dans la deuxième couche épitaxiale 402, la portion 48 de la portion 402$_b$. La portion 48 est isolée du collecteur 47 par la jonction 409 qu'elle présente à une de ses extrémités avec le contact de base 52 homéomorphe à un anneau. Elle est reliée à son autre extrémité à la portion 402$_b$ qui s'étend au-dessus du collecteur 46 de T$_{s2}$.

Dans cette portion 402$_b$, sont diffusées la zone 55 fortement dopée de type N$^+$, de profondeur moindre que l'épaisseur de la deuxième couche épitaxiale qui constitue l'émetteur de T$_{s2}$ et, autour de la zone 55, la zone 50 fortement dopée de type P$^+$ également moins profonde que la couche elle-même et qui constitue la zone de contact de base, la base de T$_{s2}$ étant constituée par la partie subsistante de la portion 402$_b$. Les zones 50 et 51 sont avantageusement diffusées par une même opération thermique. On donne à l'émetteur et au contact de base une forme interdigitée représentée figure 6.

Le dispositif est recouvert d'une couche d'oxyde isolant et passivant 56, y compris dans les gorges 410 et 411 et sur les flancs du mésa formé par l'ensemble des couches et du substrat. Des fenêtres sont ouvertes dans la couche 56 pour les différents contacts; des conducteurs métalliques sont disposés et constituent des contacts: 60 sur la zone 51, 58 sur la zone 50, 57 sur la zone 55 et 63 sur la zone 52, un conducteur 59, situé sur le passage 405 et au-dessus du segment 45 qui joint les deux transistors, établissant une connexion entre la zone 50 et la zone 51.

La résistance R$_{s2}$, comme dans l'exemple précédent la résistance R$_{51}$, est réalisée par un court-circuit localisé de la jonction base-émetteur du transistor T$_{s2}$ et repérée en 62.

La face inférieure du dispositif comporte un dépôt métallique 61 établissant une connexion entre les parties 41 et 42 du substrat.

On dispose ainsi d'un montage Darlington mixte, dont le transistor d'entrée T$_{e2}$ a un émetteur 41, une base 44, un collecteur 47, une zone de contact de base 52, une zone de contact de collecteur 51, dont le transistor de puissance T$_{s2}$ a un collecteur 46, une zone de conduction de collecteur 42, une base 49, un émetteur 55, une zone de contact de base 50, dont la résistance de sortie est en 62 et dont la résistance parallèle à la jonction émetteur-base du transistor d'entrée est élevée.

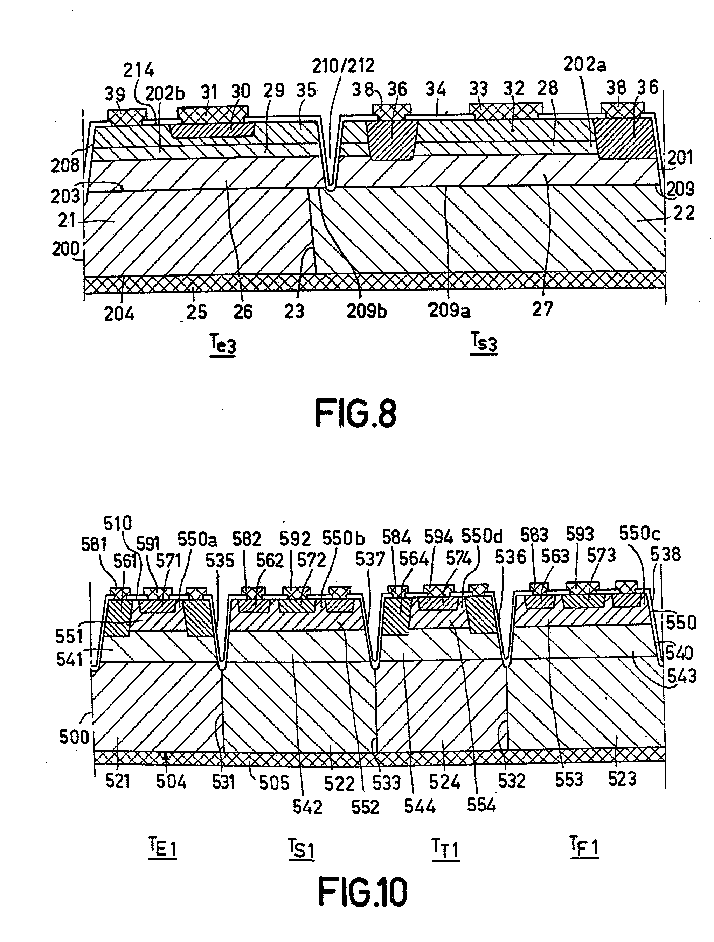

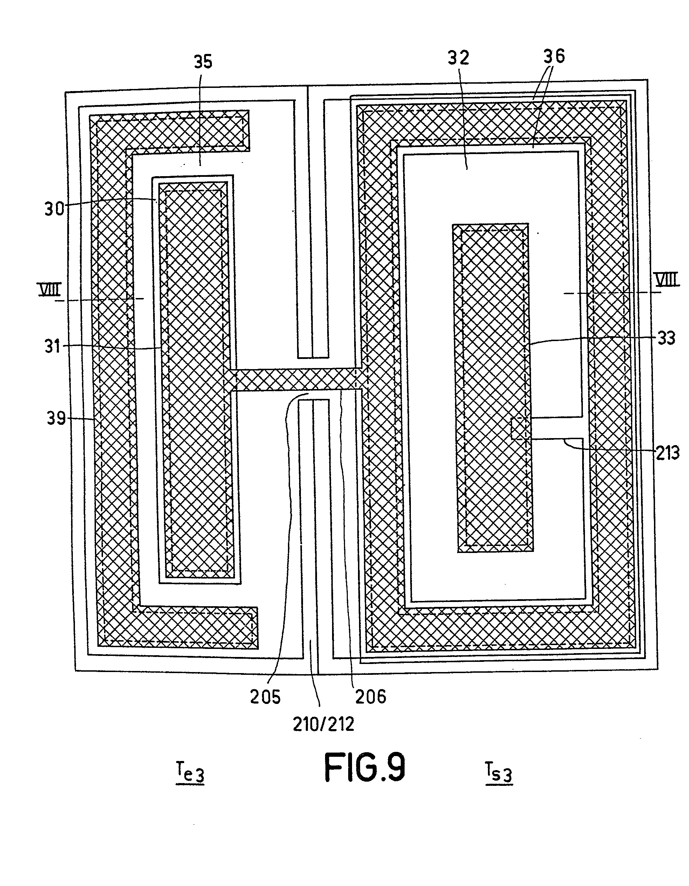

Dans le dispositif représenté sur les figures 8 et 9, qui illustrent à la fois la "deuxième configuration" et la "deuxième disposition" définies ci-dessus, deux transistors complémentaires T$_{e3}$ et T$_{s3}$ constituant également un Darlington mixte sont intégrés dans un corps semiconducteur formé d'un substrat plan 200 comportant deux portions 21 et 22 fortement dopées de types de conductivité opposés séparées par une jonction 23, d'une première couche épitaxiale 201 du type de conductivité de la portion 21 (premier type de conductivité) mais peu dopée qui s'étend sur une face 203 du substrat 200 et constitue avec la portion 22 du substrat 200 une jonction 209, et d'une deuxième couche épitaxiale 202 peu dopée du deuxième type de conductivité opposé à celui de la couche précédente et qui s'étend sur celle-ci. Un barrage isolant 212, réalisé à partir d'une gorge 210 sépare la première couche épitaxiale 201 en deux portions 26 et 27 et la deuxième couche épitaxiale 202 en deux

portions 202$_a$ et 202$_b$.

Le fond de la gorge 210 entame légèrement le substrat 200 dans la portion 22 de celui-ci du type de conductivité opposé à celui de la première couche épitaxiale, et coupe la jonction 209 en deux parties 209$_a$ et 209$_b$. Ladite jonction 209$_b$ aboutit, d'une part, au barrage isolant 212 et, d'autre part, à la jonction 23 qui sépare les portions 21 et 22 du substrat. La jonction 209$_b$ constitue avec la jonction 23, la jonction s'étendant depuis la face inférieure 204 du substrat (opposée à la face 203) jusqu'au barrage isolant 212. Cette jonction sépare parfaitement les régions 26 et 21 de la région 22.

Il est clair que la position du point de rencontre des jonctions 209$_b$ et 23 n'est pas critique, ce qui permet une grande souplesse de fabrication.

La portion de substrat 21 constitue une zone de conduction de la région d'émetteur du transistor d'entrée T$_{e3}$, "deuxième transistor" du dispositif, tandis que la portion 22 constitue le collecteur du transistor de puissance T$_{s3}$ "premier transistor" du dispositif.

Le barrage isolant sépare dans la première couche épitaxiale 201 la portion 26 qui constitue l'émetteur du "deuxième transistor" de la portion 27 qui constitue la base du "premier transistor" et dans la deuxième couche épitaxiale la portion 202$_a$ dont une partie constitue la zone 28 d'émetteur du "premier transistor" de la portion 202$_b$ dont une partie constitue la zone 29 de base du "deuxième transistor".

Une zone diffusée 30 peu profonde très dopée du premier type de conductivité constitue le collecteur du "deuxième transistor" et une zone diffusée 36 s'étendant depuis la face supérieure 214 jusqu'a une profondeur supérieure à l'épaisseur de la deuxième couche épitaxiale, très dopée, du premier type de conductivité homéomorphe à un anneau entourant la zone 32 assure la prise de contact sur la base du "premier transistor".

Une couche superficielle 208, très dopée, du même deuxième type de conductivité que la deuxième couche épitaxiale 202, diffusée dans celle-ci, constitue le contact d'émetteur 32 du "premier transistor" et le contact de base 35 du "deuxième transistor".

Une résistance en parallèle sur la jonction émetteur-base du transistor de sortie est réalisée comme dans l'exemple précédent la résistance 62, par une protubérance de la région 36 qui s'étend jusque sous le contact d'émetteur 33. Cette protubérance apparaît en 213 sur la figure 9.

Un dépôt métallique 25 sur la face arrière du dispositif assure un court-circuit de la jonction 23 entre les portions 21 et 22 du substrat et constitue en même temps un contact pour le collecteur du "premier transistor" et l'émetteur du "deuxième".

Pour assurer une meilleure planéité de la surface du dispositif, le barrage isolant 212 est interrompu par un passage 205 qui supporte une plage de connexion 206. Au niveau de la deuxième couche épitaxiale, l'isolement entre, d'une part, la base 29 du transistor d'entrée T$_{e3}$ ("deuxième transistor") et d'autre part l'émetteur 28 (et son contact 32) du transistor de sortie T$_{s3}$, ("premier transistor") est assuré par le contact 36 de base du transistor de sortie, homéomorphe à un anneau entourant complètement ledit émetteur 28 et son contact 32.

Au niveau de la première couche épitaxiale ledit passage 205 entraîne l'existence d'une zone de liaison qui constitue une résistance entre la base 27 du transistor de sortie et la zone 26 de l'émetteur du transistor d'entrée relié par la couche métallique 25 au collecteur 22 du transistor de sortie. La première couche épitaxiale étant peu dopée, cette résistance a une forte valeur et, de ce fait, ne présente pas d'inconvénients majeurs.

Les inconvénients éventuels provoqués par la présence de cette résistance en parallèle sur la jonction base-collecteur du transistor de sortie peuvent être notamment minimisés comme dans l'exemple décrit en regard des figures 6 et 7 en plaçant en série avec elle la résistance d'une portion allongée en forme de segment de la portion de première couche épitaxiale située du côté du barrage isolant opposé à celui du premier transistor analogue à la portion 45 en forme de segment décrite dans ledit exemple. Ce segment est séparé de l'émetteur proprement dit du second transistor par un barrage isolant addionnel parallèle audit barrage isolant analogue au barrage additionnel 54 parallèle au tronçon 53$_a$ du barrage 53. Une première extrémité dudit segment est reliée à la base du "premier transistor" (transistor de sortie) par ladite zone de passage, la deuxième extrémité est reliée à l'émetteur du "deuxième transistor" (ici transistor d'entrée).

On peut également, pour augmenter cette résistance, remplacer l'interruption du barrage par une discontinuité notamment en diminuant la profondeur de la gorge, ce qui constitue une solution de compromis.

La surface du dispositif est recouverte d'une couche isolante 34 dans laquelle sont ouvertes des fenêtres de contact.

Des contacts sont pris au moyen d'un dépôt métallique 31 sur le collecteur et 39 sur la base du transistor d'entrée ("deuxième transistor"), 33 sur l'émetteur et 38 sur la base du transistor de sortie ("premier transistor").

On dispose ainsi d'un montage Darlington mixte dont le transistor de sortie, "premier transistor", a un émetteur 28 dont la région de contact est en 32, une base 27 dont la région de contact de base est en 36, un collecteur 22 et dont le transistor d'entrée, "deuxième transistor", a une région de conduction d'émetteur 21, une région d'émetteur 26, une base 29 dont la région de contact de base est en 35, une région de collecteur 30.

La sortie de l'amplificateur est constituée par la couche métallique 25 qui court-circuite les régions 21 et 22. La connexion entre le collecteur du transistor d'entrée, "deuxième transistor", et la base du transistor de sortie ("premier transistor") est réalisée par la couche métallique 206. Dans cet ensemble le transistor d'entrée peut être soit de type NPN si la première couche épitaxiale est de type N, soit de type PNP si la première couche épitaxiale est de type P, le transistor de sortie étant du type complémentaire.

Le montage Darlington ainsi obtenu est de toute façon complémentaire d'un ensemble ayant la première disposition créé sur la même plaquette.

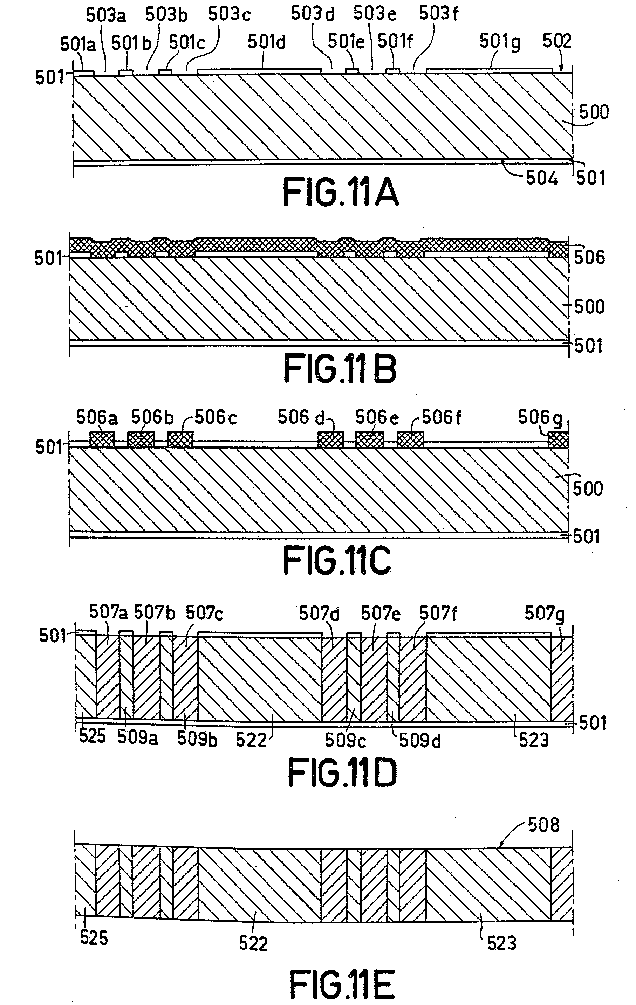

La figure 10 représente, en coupe, un amplificateur du type dit "push-pull" constitué de deux ensembles complémentaires agencés en montages Darlington mixtes, conforme à la figure 2 (à cela près que les résistances $R_s$ n'ont pas été représentées sur la figure 10) élaborés dans un corps semiconducteur constitué notamment du substrat 500 comportant des portions des deux types de conductivité, sur lequel repose une première couche épitaxiale 540 d'un premier type de conductivité, sur laquelle s'étend également une seconde couche épitaxiale 550 du second type de conductivité opposé au premier.

Pour simplifier la figure, on a donné à tous ces ensembles la première configuration (celle des figures 3, 4, 5, 6 et 7).

Le premier ensemble est constitué du transistor d'entrée $T_{E1}$, "premier transistor du premier ensemble", et du transistor de sortie $T_{S1}$, "deuxième transistor du premier ensemble". Ce premier ensemble a la première disposition.

Le deuxième ensemble est constitué du transistor d'entrée $T_{F1}$ "deuxième transistor du deuxième ensemble" de type opposé au type du transistor $T_{E1}$ et du transistor de sortie $T_{T1}$ "premier transistor du deuxième ensemble". Ce deuxième ensemble a la deuxième disposition.

Ce dispositif semiconducteur qui comporte un premier montage Darlington mixte constitué d'un premier ensemble de transistors complémentaires, le transistor d'entrée $T_{E1}$ dudit premier montage étant le "premier transistor" dudit premier ensemble et comportant notamment un émetteur 521 constitué d'une portion du substrat, une base 541 constituée d'une portion de la première couche épitaxiale, dont la région de contact 561 homéomorphe a un anneau traverse la deuxième couche épitaxiale, un collecteur constitué de la partie subsistante 551 de la portion $550_a$ de la deuxième couche épitaxiale après qu'y ait été créée notamment la région 561 de contact de base homéomorphe à un anneau et éventuellement la région 571 de contact de collecteur et des contacts métallisés 581 de base et 591 de collecteur, le transistor de sortie $T_{S1}$ dudit premier montage étant le "deuxième transistor" dudit premier ensemble et comportant notamment une zone de conduction de collecteur 522 constituée d'une portion du substrat, un collecteur 542 constitué d'une portion de la première couche épitaxiale, une base 552, partie subsistante de la portion $550_b$ de la deuxième couche épitaxiale après qu'y aient été créées la région 572 d'émetteur du premier type de conductivité et éventuellement la zone 562 de contact de base du deuxième type de conductivité toutes deux d'une profondeur inférieure à l'épaisseur de la deuxième couche épitaxiale et des contacts métallisés de base 582 et de collecteur 592, la base et le collecteur du "premier transistor" étant séparés de la base et du collecteur du "deuxième transistor" par un barrage isolant 535 s'étendant depuis la face supérieure 510 jusqu'à une profondeur supérieure à l'épaisseur des deux couches épitaxiales et qui pénètre dans le substrat, les portions 521 et 522 étant du type opposé et séparée par une jonction 531 qui constitue au moins une partie d'une jonction qui s'étend de la face 504 inférieure du substrat au barrage 535 (sur la figure elle y aboutit directement), l'émetteur 521 du "premier transistor" et le collecteur 522 du "deuxième transistor" étant court-circuités par une couche conductrice 505 déposée sur la face inférieure 504 du substrat 500 et le collecteur 551 du "premier transistor" $T_{E1}$ étant connecté à la base 552 du "deuxième transistor" comporte également dans le même corps semiconducteur un deuxième ensemble de transistors complémentaires; ledit deuxième ensemble étant complémentaire dudit premier ensemble a la deuxième disposition et est agencé également en montage Darlington mixte.

Ledit deuxième ensemble Darlington mixte est constitué notamment d'un troisième transistor $T_{F1}$ et d'un quatrième transistor $T_{T1}$, transistors bipolaires verticaux.

Ledit troisième transistor, $T_{F1}$, "deuxième transistor" du deuxième ensemble a une base constituée de la partie subsistante 553 de la portion $550_c$ de la deuxième couche épitaxiale 550 dont la région de contact éventuelle est en 563, un collecteur 573 constitué d'une région surdopée du premier type de conductivité incluse dans ladite portion $550_c$ de la deuxième couche épitaxiale, un émetteur constitué d'une portion 543 de la première couche épitaxiale et d'une portion 523 du substrat du premier type de conductivité qui est sous-jacente à la portion 543 et constitue une zone de conduction.

Ledit quatrième transistor $T_{T1}$, "premier transistor" du deuxième ensemble a une base 544 constituée d'une portion de la première couche épitaxiale dont la région de contact 564 surdopée homéomorphe a un anneau traverse la deuxième couche épitaxiale, un collecteur 524 constitué d'une portion de substrat du deuxième type de conductivité, un émetteur 554 (dont la région de contact éventuelle est en 574) constitué par la partie subsistante de la portion $550_d$ dela deuxième couche épitaxiale.

Les différentes portions utilisées du substrat d'une part, de la première couche épitaxiale d'autre part et de la deuxième couche épitaxiale de troisième part sont respectivement coplanaires entre elles et avec les portions utilisées pour le "premier" et le "deuxième" transistors du premier ensemble.

Les deux portions 523 et 524 de substrat de type opposé utilisées pour lesdits "troisième" et "quartrième" transistors (respectivement "deuxième" et "premier transistors" du deuxième ensemble) sont contiguës et forment une jonction P/N 532 qui constitue au moins une partie d'une jonction qui s'étend depuis la face inférieure du substrat jusqu'à un barrage isolant 536 qui s'étendant depuis la face supérieure 510 jusqu'à une profondeur supérieure à l'épaisseur des deux couches épitaxiales sépare entièrement dans les deux dites couches au moins une partie des portions utilisées pour le "troisième transistor" $T_{F1}$, des portions utilisées pour le "quatrième transistor" $T_{T1}$ et se prolonge jusqu'au substrat.

Les régions des "premier" et "deuxième transistors" du premier ensemble constituées par des portions de couches épitaxiales sont séparées des régions adjacentes des "troisième" et "quatrième transistors" (respectivement "deuxième" et "premier transistors" du deuxième ensemble) par un barrage isolant 537 s'étendant depuis la face supérieure 510 jusqu'à une profondeur supérieure à l'épaisseur des deux dites couches épitaxiales c'est-à-dire jusqu'au substrat.

Le collecteur 573 du troisième transistor étant réuni à la base 544 du quatrième transistor par une pellicule métallique non représentée sur la figure, et les quatre régions créées dans le substrat étant court-circuitées par une électrode conductrice 505 créée sur la face 504 inférieure du substrat 500, le troisième et le quatrième transistors constituent un deuxième montage amplificateur Darlington du type opposé à celui du premier ensemble, le transistor d'entrée dudit deuxième montage étant le troisième transistor $T_{F1}$ et le transistor de sortie le quatrième transistor $T_{T1}$.

Le deuxième ensemble constitue avec le premier ensemble un amplificateur "push-pull" dont les entrées sont les bases du "premier transistor" du premier ensemble et du "deuxième transistor" du deuxième ensemble ("troisième transistor") et la sortie l'électrode conductrice créée sur la face inférieure du substrat.

Les deux ensembles complémentaires agencés en montages Darlington constituant un amplificateur "push-pull" peuvent présenter deux topologies différentes.

Dans la première topologie qui vient d'être décrite, le substrat est partagé en quatre portions de types alternés de conductivité, 522 et 523 étant du premier type de conductivité tandis que 521 et 524 sont du deuxième type de conductivité.

Les portions de substrat contiguës appartenant à deux ensembles différents sont de type opposé et séparées par une jonction. Celle-ci constitue alors au moins une partie d'une jonction qui s'étend de la face inférieure du substrat au barrage. Sur la figure 10 qui illustre la première topologie, les portions 522 et 524 contiguës du substrat sont séparées par une jonction 533 qui rejoint directement le fond du barrage isolant 537.

Cette jonction 533 pourrait aboutir comme dans la "deuxième configuration" du côté du barrage 537 où la portion de substrat est du premier type de conductivité.

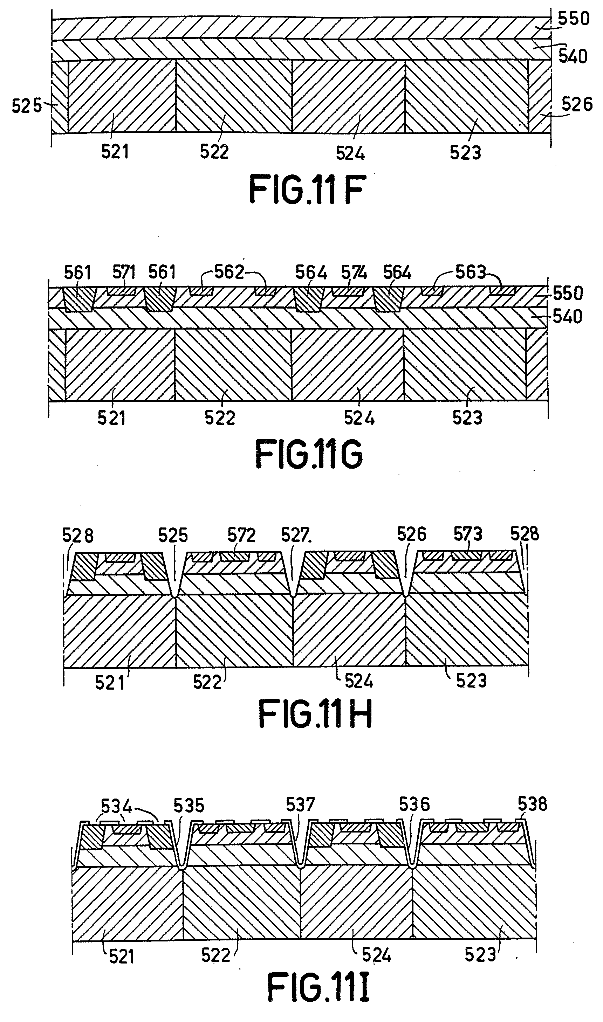

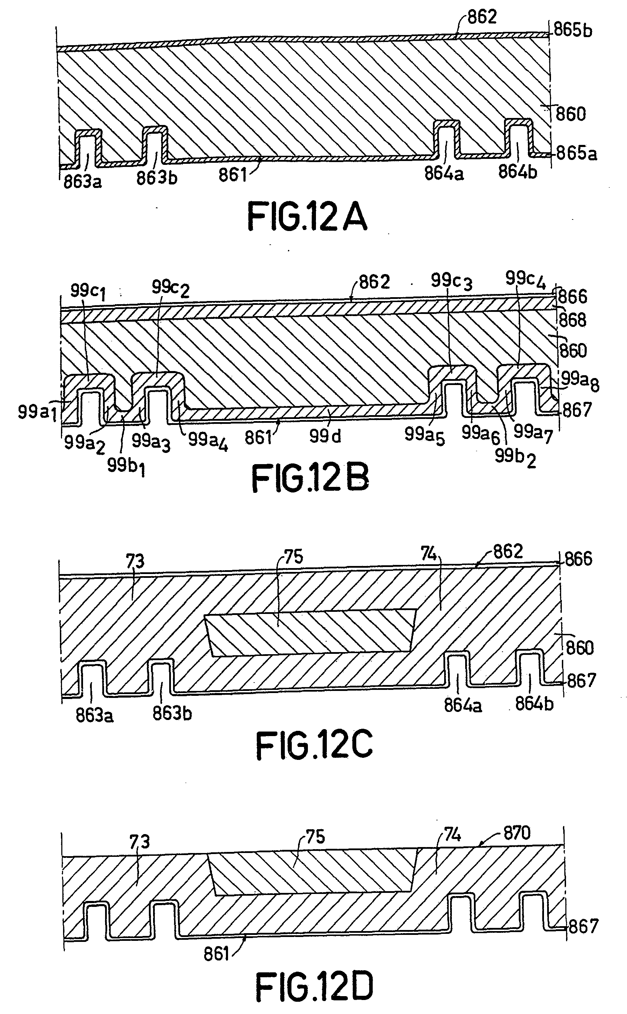

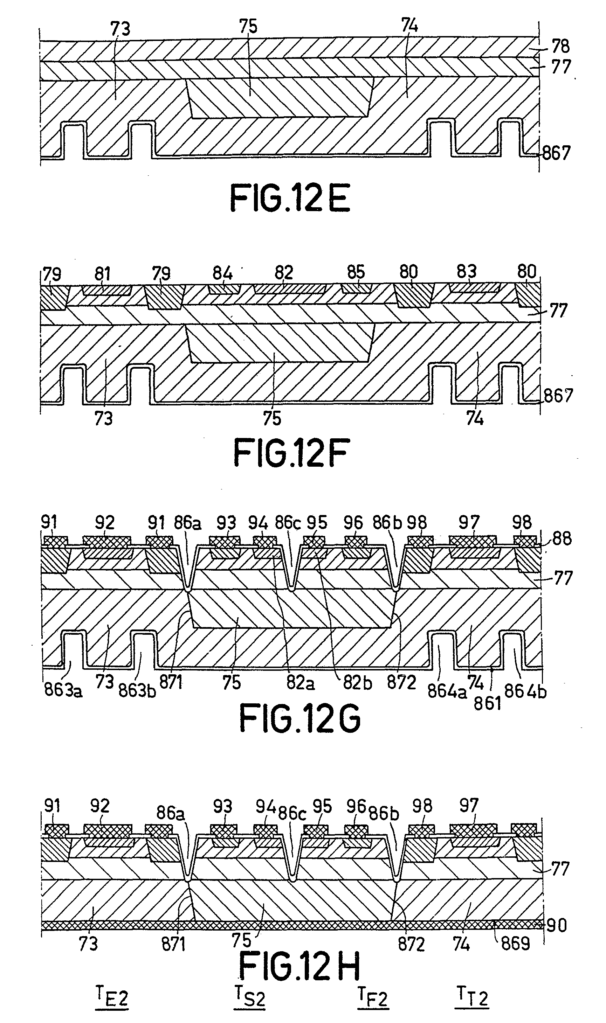

Dans la seconde topologie représentée figure 12 les portions de substrat contiguës appartenant à deux ensembles différents sont de même type.

Les quatre portions 521, 522, 523 et 524 du substrat sont court-circuitées par une électrode métallisée 505 qui constitue la borne commune de sortie référencée A sur la figure 2 et qui est déposée sur la face inférieure 504 du substrat.

La face supérieure du dispositif est recouverte d'une couche isolante et passivante 538 dans laquelle ont été pratiquées des ouvertures non référencées sur la figure permettant la création de contacts métalliques mentionnés ci-dessus.

Cette couche d'oxyde contribue également aux barrages isolants en recouvrant les gorges déjà mentionnées.

Le collecteur du transistor d'entrée $T_{E1}$ est relié à la base du transistor de sortie $T_{S1}$ par un chemin métallisé qui passe d'un transistor à l'autre en un point où le barrage isolant 535 est interrompu.

De même, le collecteur du transistor d'entrée $T_{E1}$ est relié à la base du transistor de sortie $T_{S1}$ par un chemin métallisé qui passe d'un transistor à l'autre en un point où le barrage isolant 536 est interrompu.

Les contacts métallisés 581 et 583 des bases des deux transistors d'entrée qui constituent les entrées de l'amplificateur portent avantageusement des connexions non représentées sur la figure.

Ces interruptions dans les barrages 535 et 536 ainsi que les deux chemins métallisés ne sont pas représentés sur la figure 10. Ils sont tout à fait analogues à ceux qui ont été représentés sur les figures 3, 4, 5, 8 et 9.

Des résistances de sortie $R_S$ des deux ensembles peuvent être placées d'une manière identique à celle qui a été décrite pour le premier exemple. Elles ne sont pas représentées sur la figure 10.

De même, on peut adopter une topologie analogue à celle des figures 6 et 7 permettant d'augmenter la valeur des résistances en parallèle sur la jonction émetteur-base du transistor $T_{E1}$ et sur la jonction collecteur-base du transistor $T_{F1}$ pour éviter que celle-ci ne jouent éventuellement un rôle néfaste.

Il est à remarquer que le barrage isolant 537 n'a pas à être interrompu. Si bien que la topologie du premier ensemble constitué des transistors $T_{E1}$ et $T_{S1}$ est indépendante de la topologie du second ensemble constitué des transistors $T_{F1}$ et $T_{T1}$.

On dispose ainsi d'un amplificateur "push-pull" sysmétrique conforme au schéma de la figure 2, dont le point A, matérialisé dans le dispositif par l'électrode métallique de la face arrière du substrat, constitue la sortie basse fréquence mais n'est pas à la haute tension, ce qui constitue une assurance de sécurité car cette électrode étant reliée au boîtier du dissipateur, l'usager ne peut toucher la haute tension. Par ailleurs, du fait de la soudure du substrat sur une embase, tout le dispositif est à la même température et on peut éviter la circuiterie supplémentaires nécessaire avec les éléments discrets pour assurer la stabilité en température.

La fabrication d'un ensemble de transistors selon l'invention comporte notamment les opérations suivantes:

Dans une plaquette d'un type initial de conductivité, des impuretés donnant le type de conductivité opposé au précédent sont introduites localement au moins sur une certaine épaisseur de substrat avec une concentration supérieure à celle de ladite plaquette pour obtenir dans celle-ci des portions des deux types de conductivité, puis une première couche épitaxiale faiblement dopée est déposée sur l'une des grandes faces de ladite plaquette sur laquelle affleure des portions des deux types de conductivité, puis une deuxième couche épitaxiale faiblement dopée du type de conductivité opposé à celui de ladite première couche épitaxiale est déposée sur celle-ci, ensuite des régions localisées sont créées dont au moins deux du type de conductivité de la première couche épitaxiale, l'une profondeur supérieure à l'épaisseur de la deuxième couche épitaxiale étant destinée à constituer le contact de base du premier transistor, l'autre, destinée à constituer une zone externe du deuxième transistor, étant incluse dans la deuxième couche épitaxiale, le barrage isolant est élaboré, les contacts et les connexions sont créés.

L'introduction localisée dans la plaquette du type initial de conductivité, d'impuretés destinées à créer dans la plaquette des portions coplanaires du type opposé peut notamment être mise en oeuvre selon deux modes différents.

Selon un premier mode de mise en oeuvre du procédé de fabrication du dispositif selon l'invention, des portions de type opposé dans un substrat d'un type de conductivité initial peuvent être réalisées par thermomigration, par exemple thermomigration d'aluminium dans un substrat en silicium comme il est décrit ci-dessous en regard de la figure 11 dont les schémas 11A à 11F représentent en coupe les différentes étapes de cette élaboration.

On part par exemple d'une plaquette 500 de silicium de type N ou $N^+$, dopée à l'antimoine par exemple à la concentration de $5.10^{18}$ atomes/cm³ environ, d'un diamètre de 75 mm, d'une épaisseur de l'ordre de 350 $\mu$m dont les surfaces sont rodées mais non polies et dont les faces principales sont dans le plan cristallin (III).

On soumet cette plaquette à une oxydation thermique de manière à créer à sa surface une couche d'oxyde 501 thermique d'une épaisseur de 2 micromètres.

Au moyen d'une couche de laque photosensible non représentée sur les figures on protège sur l'une des faces 502 de la plaquette choisie comme face active, les emplacemens correspondant aux portions du substrat que l'on veut garder de type N. Avec une solution à l'acide fluorhydrique bien tamponnée, on grave de manière classique la couche d'oxyde aux emplacements non protégés référencés 503 indicé: $503_a$, $503_b$, etc... et on les met à nu. La plaquette à ce stade est représentée figure 11A. Les plages d'oxyde maintenues sont désignées par 501 indicé: $501_a$, $501_b$, etc...

L'expérience montre que, pour éviter que l'aluminium fondu ne se mette en boule au début de l'opération de thermomigration, il importe de donner aux emplacements 503 une forme allongée de fente d'une largeur de 50 $\mu$m à 500 $\mu$m et avantageusement de 300 à 400 $\mu$m, et d'une longueur de 5 à 10 fois la largeur. Pour une longueur d'environ 2 mm nécessaire pour la création du dispositif selon l'invention, une largeur de 300 à 400 $\mu$m est excellente. On obtient ainsi, dans le substrat, des canaux de type P d'une largeur insuffisante pour créer la plupart des dispositifs.

Mais l'expérience a montré à la Demanderesse qu'il était possible d'obtenir des portions de type P plus larges en créant, à partir d'une pluralité de fentes sensiblement parallèles, séparées par une distance de 1 $\mu$m à 50 $\mu$m, par exemple 15 $\mu$m, une pluralité de canaux.

Au cours de la thermomigration, la diffusion latérale est extrêmement faible, mais, au cours des nombreux traitements thermiques ultérieurs, elle est suffisante pour que l'intervalle entre deux canaux voisins obtenus par thermomigration soit annihilé.

Chaque portion à transformer est donc recouverte d'au moins une pluralité de ces fentes, celles-ci s'étendant sur toute la surface de ladite portion.

Sur la figure 11A on a représenté deux groupes de fentes destinés chacun à la création d'une portion de substrat utilisable pour l'élaboration d'un dispositif selon l'invention; ces deux groupes sont séparés entre eux par la plage d'oxyde $501_d$ et des autres groupes par les plages $501_a$ et $501_g$.

Les fentes $503_a$, $503_b$ et $503_c$, séparées par les plages d'oxyde $501_b$, $501_c$, constituent le premier groupe et les fentes $503_d$, $503_e$, $503_f$, séparées par les plages d'oxyde $501_e$ et $501_f$, constituent le second groupe.

Au cours de l'étape suivante, on dépose, par exemple par évaporation sous vide, sur toute la plaquette, une couche d'aluminium 506 de 6 à 10 $\mu$m d'épaisseur. La plaquette à ce stade est représentée sur la figure 11B.

Au moyen d'une couche photosensible, on crée un masque, non représenté sur la figure, dont la forme est exactement l'inverse de celle du masque précédent.

Par une attaque chimique, on élimine toutes les plages d'aluminium déposées sur des plages restantes ($501_a$, $501_b$, etc...) de la couche d'oxyde et on garde les plages d'aluminium ($506_a$, $506_b$, etc...) déposées entre les plages d'oxyde, dans les fentes 503, directement sur le silicium. On élimine alors le masque. La plaquette à ce stade est représentée figure 11C.

On recuit alors la plaquette sous azote pendant 15 minutes à 560°C.

Puis, pour obtenir le gradient de température nécessaire à la thermomigration, on place ladite plaquette étant vers le haut. La plaquette est par induction, la face active 502 de ladite plaquette étant versle haut. La plaquette est placée sur un suscepteur en graphite, enrodé d'une couche de carbure de silicium recouverte elle-même d'une couche de silicium. On peut obtenir une thermomigration pour une température du suscepteur (à laquelle la température de la face arrière de la plaquette est pratiquement égale) comprise entre 1050°C et 1200°C. Avantageusement, elle est comprise entre 1140 et 1160°C; dans l'exemple décrit elle est de 1150°C. L'écart de température entre la face active et la face arrière de la plaquette peut être compris entre 5°C et 70°C. Dans l'exemple décrit, la température de la face active était de l'ordre de 1100°C. L'écart de température est obtenu par un balayage avec un fort débit (par exemple de 120 l/minute) d'hydrogène qui refroidit la face active de la plaquette. Cette opération dure de 10 à 20 minutes.

L'aluminium migre dans la direction du gradient et, si celui-ci est bien régle, cette direction est préférentiellement perpendiculaire au plan de la face 502. La perpendicularité absolue n'est pas nécessaire. La direction du gradient peut être dans un cône de 30° et même 45° d'angle au sommet et d'axe perpendiculaire aux faces de la plaquette.

Sur la figure 8, l'angle de la jonction 23 avec les plans des faces de la plaquette a été délibérément représenté différent du droit.

Ainsi sont créés les canaux référencés 507 indicé, de type P, tandis que les zones 525, $509_a$, $509_b$, 522, $509_c$, $509_d$, 523 restent du type N. La plaquette a ce stade est représentée figure 11D.

Au cours de la thermomigration, la diffusion latérale de l'aluminium qui migre en raison du gradient thermique est pratiquement nulle et les zones dopées P ne débordent pas latéralement des canaux ou volumes sous-jacents aux fentes 503 mais, par suite de la diffusion latérale qui survient ultérieurement au cours de la fabrication du dispositif (au cours des épitaxies à 1170°C et de diffusion à une température de l'ordre de 1100°C) les canaux $507_a$, $507_b$, $507_c$ d'une part $507_d$, $507_e$, $507_f$ d'autre part se joignent pour constituer une seule zone 521 et une seule zone 524 (voir figure 11F) en annihilant les zones $509_a$, $509_b$, $509_c$, $509_d$ de type N. Ces zones 521 et 524 comportent une quantité de $5.10^{19}$ atomes d'aluminium au cm³.

Si, par accident, il devait rester dans l'intérieur d'une zone P, une mince zone intercalaires de type N, sa présence serait sans conséquence, en particulier parce que les différentes portions du substrat sont court-circuitées sur la face arrière. On peut d'ailleurs, si nécessaire, rajouter avant les épitaxies une légère opération de diffusion de bore sur les zones P pour éviter d'avoir des zones séparées sur l'émetteur du transistor d'entrée.

Cette opération, qui n'est pas représentée sur la figure, présente l'avantage supplémentaire d'entraîner entre la surface des portions N et celle des portions P du substrat une légère dénivellation qui se répercute sur la surface des couches épitaxiales et permet de fixer avec précision la position des éléments créés à partir de la face active, notamment celle des barrières isolantes par rapport aux jonctions correspondantes entre deux portions contiguës de substrat.

Il est à noter que l'on peut limiter la profondeur des impuretés introduites à une valeur inférieure à l'épaisseur de la plaquette enlaissant susbsister du côté de la face opposée à la face d'introduction une couche du type initial de conductivité que l'on élimine ultérieurement à partir de la dite face opposée, par exemple juste avant dépôt de l'électrode métallique sur la face arrière et soudure par cette face sur l'embase. On dispose ainsi, pendant la durée des opérations de fabrication, d'une plaquette plus épaisse et donc plus résistante mécaniquement.

La face supérieure 508 de la plaquette est alors préparée pour le dépôt épitaxique.

Les régions superficielles des zones de type P étant extrêmement perturbées et pouvant présenter des concentrations d'impuretés très différentes des concentrations en volume, aussi bien près d'une face que près de l'autre face, après avoir enlevé les plages restantes de la couche 501 d'oxyde, on élimine, par exemple par décapage chimique, à partir de l'une et de l'autre faces une épaisseur de silicium de 30 $\mu$m. La plaquette à ce stade est représentée figure 11E.

Cette même surface active est ensuite polie par rodage et on effectue alors, par des techniques très connues, le dépôt d'une première couche épitaxiale 540 de silicium de type N dopée à l'arsenic à la concentration de

$10^{15}$ atomes/cm³ donnant une résistivité de 3 Ωcm, d'une épaisseur de 10 μm. Puis, on dépose une deuxième couche épitaxiale 550 de silicium de type P dopée au bore à la concentration de $3 \times 10^{15}$ atomes/cm³ d'une épaisseur de 7 μm.

La plaquette à ce stade est prête pour les opérations de diffusion. Elle est montrée figure 11F sur laquelle les zones de type P, 521 et 524, ont été représentées comme achevées.

Sur des plages correspondant aux zones de contact de base des deux transistors PNP $T_{E1}$ et $T_{T1}$, on effectue une première diffusion de phosphore pour l'obtention des zones 561 et 564 de type $N^+$ atteignant la première couche épitaxiale.

Puis sur des plages correspondant aux zones de contact de collecteur du transistor $T_{E1}$, de l'émetteur du transistor $T_{T1}$, et des bases des transistors $T_{F1}$ et $T_{S1}$ on effectue une diffusion de bore pour obtenir des zones 571, 574, 562, 563 de type $P^+$ fortement dopées, de profondeur inférieure à l'épaisseur de la deuxième couche épitaxiale. La plaquette à ce stade est représentée figure 11G.

Ensuite, selon des plages correspondant à l'émetteur du transistor $T_{S1}$ et au collecteur du transistor $T_{F1}$ on effectue une diffusion de phosphore pour obtenir des zones 572 et 573 de type $N^+$ fortement dopées, de profondeur inférieure à l'épaisseur de la deuxième couche épitaxiale.

Des gorges 525, 526, 527 de profondeur suffisante pour atteindre le substrat, d'une largeur minimale, sont creusés par un décapage adéquat pour séparer les divers transistors les uns des autres, selon un tracé laissant subsister, pour le support des connexions, des passages étriots les interrompant non représentés sur la figure. En même temps que ces gorges 525, 526 et 527, des gorges 528 traçant les limites du dispositif, par exemple au sein d'une plaquette dans laquelle sont formés simultanément plusiers dispositifs identiques, sont également creusées et donnent au dispositif une forme de mésa. La plaquette à ce stade est représentée figure 11H.

La surface du dispositif est revêtue d'une couche 538 d'oxyde de silicium passivante et isolante. Cette couche recouvre les gorges 525, 526, 527 avec lesquelles elle constitue les barrages isolants 535, 536, 537.

Dans cette couche 538 sont ouvertes des fenêtres de contact 534. La plaquette à ce stade est représentée figure 11I.

Un dépôt d'aluminium est effectué et les différentes prises de contact et les connexions sont obtenues par une opération de gravure appropriée (voir figure 10): contact de base $T_{E1}$ en 581, contact de collecteur du transistor $T_{E1}$ en 591, contact d'émetteur du transistor $T_{S1}$ en 592, contact de base du transistor $T_{S1}$ en 582, contact de base du transistor $T_{F1}$ en 583, contact de collecteur du transistor $T_{F1}$ en 593, contact d'émetteur du transistor $T_{T1}$ en 594 et contact de base du transistor $T_{T1}$ en 584.

Les connexions entre le contact de collecteur 591 du transistor $T_{E1}$ et le contact de base du transistor $T_{S1}$, et entre le contact de collecteur 593 du transistor $T_{F1}$ et le contact de base du transistor $T_{T1}$, obtenues en même temps que lesdits contacts ne sont pas représentés sur la figure.

Les contacts d'émetteurs des transistors $T_{E1}$ et $T_{F1}$ et les contacts de collecteurs des transistors $T_{S1}$ et $T_{T1}$ sont obtenus au moyen d'un dépôt d'aluminium 505 sur la face arrière de la plaquette. Le dispositif obtenu est le dispositif représenté figure 10 dont la structure a été décrite ci-dessus.

Le procédé de réalisation du dispositif selon l'invention est extrêmement simple et fiable. Le dispositif ne comporte notamment aucune couche enterrée. Les connexions sont particulièrement faciles à réaliser. La sécurité qu'il procure aux usagers est excellente. La stabilité thermique est assurée. La réalisation des portions du substrat du type opposé au type initial est rapide, elle comporte peu d'opérations, elle est donc économique.

Les différents schémas 12A à 12H qui composent la figure 12 représentent les différentes étapes de l'élaboration d'un amplificateur dit "push-pull" selon l'invention réalisé suivant le deuxième mode de mise en oeuvre du procédé de fabrication du dispositif selon l'invention. Selon ce deuxième mode, des portions de type opposé dans un substrat d'un type initial de conductivité sont obtenues par diffusion.

Comme le substrat doit présenter lui-même la rigidité mécanique nécessaire aux manipulations, son épaisseur risque de rendre prohibitive la durée d'une opération de diffusion dans toute son épaisseur: il est possible dans ce cas de pratiquer dans la plaquette, avant la diffusion, des cavités réduisant localement l'épaisseur à une valeur favorable.

On creuse donc à partir d'une première face de la plaquette au moins un groupe de cavités; chaque groupe comportant au moins une cavité d'une profondeur comprise entre 0,25 et 0,40 fois l'épaisseur de la plaquette, la longueur et la largeur de chacune des cavités étant inférieure à 1 mm et la distance entre deux cavités d'un même groupe étant de une fois à une fois et demie la profondeur de diffusion désirée. A partir du fond de ladite cavité on crée, localement, avec les impuretés à introduire au moins une zone diffusée d'une profondeur comprise en 0,25 et 0,40 fois l'épaisseur de la plaquette. Ensuite, à partir de la deuxième face, opposée à ladite première face, on amincit la plaquette jusqu'à ce que ladite zone diffusée du type opposé affleure la nouvelle surface de ladite plaquette sur cette dite deuxième face. On dépose successivement sur cette nouvelle surface la première puis la deuxième couche épitaxiale. A partir de cette deuxième face, on crée, notamment par diffusions dans les couches épitaxiales, les régions d'au moins un dit "premier" et un dit "deuxième" transistor séparées par un barrage isolant.

La zone diffusée localement dans le substrat d'une part et, au moins une portion du substrat du type initial, d'autre part, constituent, l'une, au moins une partie de la région de collecteur de l'un des transistors et l'autre, au moins une partie de la région d'émetteur de l'autre transistor.

Sur cette dite deuxième face de la plaquette, on réalise alors les métallisations des contacts et des connexions et à partir de ladite première face de la plaquette et de préférence juste avant de souder par cette face le dispositif sur une embase, on élimine une couche d'une épaisseur au moins égale à la profondeur des cavités et on réalise sur la nouvelle première face la métallisation de contact des régions créées dans le substrat.

On choisit une plaquette 860 de type N ou $N^+$ d'une épaisseur suffisante comprise entre 300 $\mu$m et 600 $\mu$m (450 $\mu$m dans l'exemple) pour qu'elle bénéficie de la rigidité et de la solidité lui permettant de supporter les manipulations, dopée à l'antimoine par exemple à la concentration de $5.10^{18}$ atomes/cm³ environ.

La figure 12A représente cette plaquette dans laquelle, à partir d'une première face 861, on a pratiqué deux groupes de deux cavités $863_a$ et $863_b$ d'une part, $864_a$ et $864_b$ d'autre part, d'une profondeur de 150 $\mu$m (comprise entre 0,25 et 0,40 fois l'épaisseur de ladite plaquette) de section carrée, d'un côte de préférence inférieur à 1 mm (700 $\mu$m dans l'exemple). Les deux cavités d'un même groupe sont séparées par une distance de 200 $\mu$m (de une fois à une fois et demie la profondeur de diffusion désirée). Les deux groupes de cavités sont séparés par une distance d'au moins 1 mm.

La diffusion est effectuée à partir des deux faces de la plaquette: la face destinée à supporter les couches épitaxiales ou face active ou supérieure et la face inférieure qui lui est opposée à partir de laquelle sont pratiquées lesdites cavités.

L'oxyde étant un mauvais masque pour une diffusion profonde, on a réalisé directement sur chacune des deux faces dénudées 861 et 862 de la plaquette une couche dopée au bore $865_a$ et $865_b$ d'une é-aisseur de 1 $\mu$m. Le dépôt de bore est effectué à 1100°C pendant 1 heure.

On effectue alors un recuit de diffusion sous air à 1280°C pendant environ 120 heures. Le bore diffuse dans la plaquette et il se crée deux légères couches d'oxyde 866 et 867 sur chacune des faces de la plaquette.

La figure 12B représente la plaquette en cours de diffusion. Une première zone 868 de type P se crée à partir de la face 862 et une deuxième zone de type P de même profondeur 99 se crée à partir de la face 861.

Dans cette couche, les portions indicées $_a$ au flanc des cavités sont dues à la diffusion latérale.

La figure 12C représente la plaquette à la fin de l'opération de diffusion. La distance entre les cavités $863_a$ et $863_b$ d'une part et entre les cavités $864_a$ et $864_b$ d'autre part, étant comprise entre une fois et une fois et demie la profondeur de diffusion, les portions $99_{a2}$ et $99_{a3}$ d'une part et $99_{a6}$ et $99_{a7}$ d'autre part de la couche 99 se rejoignent. L'épaisseur (inférieure à 300 $\mu$m dans l'exemple) entre le fond des cavités et la surface 862 étant plus petite que le double de la profondeur de diffusion (150 $\mu$m), les portions $99_{c1}$, $99_{c2}$, $99_{c3}$ et $99_{c4}$ de la couche 99 rejoignent la couche 868.

Il se crée ainsi deux vastes zones 73 et 74 de type P situées de part et d'autre d'une zone subsistante 75 de type N d'une épaisseur voisine de 130 à 140 $\mu$m, l'oxydation des surfaces ayant absorbé de part et d'autre de la plaquette une épaisseur de 2 à 3 $\mu$m de silicium.

L'étape suivante consiste à amincir par des voies mécaniques et/ou chimiques la plaquette à partir de la face 862 et à éliminer sur cette surface une épaisseur correspondant à la couche 868 de type P diffusée à partir de cette face.

La région 75 affleure la nouvelle face 870 de la plaquette opposée à la face 861. Elle sépare les deux portions 73 et 74. La plaquette à ce stade est représentée figure 12D. Une fois polie, elle constitue le substrat sur lequel sont effectuées les épitaxies.

On pourrait, de manière analogue, obtenir par diffusion un substrat comportant des portions P et des portions N en partant d'une plaquette de type P et en diffusant du phosphore.

Au cours de l'étape suivante, par des techniques connues, on effectue le dépôt d'une première couche épitaxiale 77 de silicium de type N dopée à l'arsenic à la concentration de $10^{15}$ atomes/cm³ d'une épaisseur de 10 $\mu$m. Puis on dépose une deuxième couche épitaxiale 78 de silicium de type P dopée au bore à la concentration de $3 \times 10^{15}$ atomes/cm³ d'une épaisseur de 7 $\mu$m. La plaquette à ce stade est représentée figure 12E.

Selon des plages correspondant aux zones de contact de base des transistors $T_{E2}$ et $T_{T2}$, on effectue une première diffusion de phosphore pour l'obtention de zones 79 et 80 de type $N^+$ atteignant la première couche épitaxiale. Puis, selon des plages correspondant aux zones de contact de collecteur du transistor $T_{E2}$, de l'émetteur du transistor $T_{T2}$ et des bases des transistors $T_{S2}$ et $T_{F2}$, on effectue une diffusion de bore pour obtenir des zones respectivement 81, 83 et 82 de type $P^+$ fortement dopées, de profondeur inférieure à l'épaisseur de la seconde couche épitaxiale. Ensuite, selon des plages correspondant à l'émetteur du transistors $T_{S2}$ et au collecteur du transistor $T_{F2}$, on effectue une diffusion de phosphore pour obtenir des zones 84 et 85 de type $N^+$, fortement dopées, de profondeur inférieure à l'épaisseur de la deuxième couche épitaxiale. La plaquette à ce stade est représentée figure 12F.

Des gorges 86 de profondeur suffisante pour atteindre le substrat, d'une largeur minimale, sont creusées, par exemple par attaque plasma, pour séparer les divers transistors les uns des autres selon un tracé laissant susbsister des passages jouant alors le rôle de résistances, non représentées sur la figure. Les deux gorges $86_a$ et $86_b$ aboutissent respectivement, la première à la jonction 871 entre les portions de substrat 73 et 75 et la seconde à la jonction 872 entre les portions de substrat 74 et 75.

La gorge $86_c$ sépare la base $82_a$ de $T_{S2}$, de la base $82_b$ de $T_{F2}$, deux transistors de même type.

En même temps que les gorges 86, des gorges traçant les limites du dispositif, non représentées sur les figures, sont également creusées et donnent au dispositif une forme de mésa.

La surface du dispositif, y compris les gorges 86 est revêtue d'une couche d'oxyde de silicium, isolante et passivante, 88 dans laquelle sont ouvertes des fenêtres de contact. Un dépôt d'aluminium est effectué et les différentes prises de contact et de connexions sont obtenues par une opération de gravure appropriée: contact de base du transistor $T_{E2}$ en 91, contact de collecteur du transistor $T_{E2}$ en 92, contact d'émetteur du transistor $T_{S2}$ en 93, contact de base du transistor $T_{S2}$ en 94, contact de base du transistor $T_{F2}$ en 95, contact de collecteur du transistor $T_{F2}$ en 96, contact d'émetteur du transistor $T_{T2}$ en 97 et contact de base du transistor $T_{T2}$ en 98. La plaquette a ce stade est représentée figure 12G. Son épaisseur a été suffisante pour éviter qu'elle ne soit détériorée au cours des manipulations.

Juste avant soudure de préférence, on élimine à partir de la face 861 une couche du substrat d'une épaisseur supérieure à la fois à l'épaisseur de la couche $99_d$ et à la profondeur des cavités 863 et 864. Ainsi, la zone 75 affleure la nouvelle surface 869 pour permettre la prise de contact sur le collecteur de $T_{S2}$ et l'émetteur de $T_{F2}$. D'autre part, les cavités étant éliminées, la transmission thermique à l'embase est excellente. La jonction 871 entre les régions 73 et 75 et la jonction 872 entre les régions 74 et 75 s'étendent de la face 869 aux barrages $86_a$ et $86_b$. La plaquette a alors une épaisseur de l'ordre de 150 $\mu$m.

Les contacts d'émetteurs des transistors $T_{E2}$ et $T_{F2}$ et les contacts de collecteurs de $T_{S2}$ et $T_{T2}$, en même temps que la connexion entre ces régions, sont obtenus au moyen d'un dépôt d'aluminium 90 sur la face arrière de la plaquette. La plaquette est alors soudée à l'embase.

La plaquette juste avant soudure est représentée figure 12H. Elle comporte deux ensembles Darlington de types opposés constituant un amplificateur "push-pull" symétrique correspondant à la figure 2.

Dans cette dernière topologie, le substrat est partagé en trois portions 73, 75 et 74; la portion 75 constitue des parties externes de deux transistors différents de même type.

Ce mode de mise en oeuvre du procédé d'obtention du dispositif selon l'invention présente l'avantage de n'employer que des procédés très bien connus et donc d'être facilement utilisable.

Tous les exemples décrits ont trait à des amplificateurs Darlington mais on peut utiliser le dispositif pour d'autres agencements comportant deux transistors complémentaires.

## Revendications

1. Dispositif semiconducteur comportant un corps semiconducteur comprenant au moins un premier ($T_{e1}$; $T_{s3}$) et un deuxième ($T_{s1}$; $T_{e3}$) transistors verticaux, bipolaires et complémentaires, chaque transistor comprenant une région de base et deux régions externes faisant office de région d'emetteur et de région de collecteur, ledit corps étant constitué notamment d'un substrat (100; 200) recouvert d'une première couche épitaxiale (101; 201) d'un premier type de conductivité sur laquelle s'étend une deuxième couche épitaxiale (102; 202) du deuxième type de conductivité opposé au premier, la région de base (4; 27) du premier transistor et au moins une partie (5; 26) d'une région externe du deuxième transistor étant formées par des portions coplanaires de la première couche épitaxiale, la région de base (7; 29) du deuxième transistor étant formée par une première portion (102b; 202b) de la deuxième couche épitaxiale, et une première portion (2; 22) du substrat (100; 200) constituant au moins une partie de la région de collecteur (2,5; 22) d'un ($T_{s1}$; $T_{s3}$) desdits premier et deuxième transistors cependant qu'un barrage isolant (170; 210) s'étend depuis la face supérieure (140; 214) au moins jusqu'au substrat (100; 200) qui est contacté par une électrode (13; 25) sur sa face inférieure (104; 204), caractérisé en ce que au moins une partie (6; 28) d'une région externe du premier transistor est formée par une seconde portion (102a; 202a) de la deuxième couche épitaxiale, coplanaire de la première portion de ladite couche, en ce que au moins une partie de la région d'émetteur (1; 21) d'un transistor ($T_{e1}$; $T_{e3}$) est constituée par une deuxième portion (1, 21) du substrat (100; 200) contigüe à et coplanaire avec la première portion (2; 22) du substrat et de type de conductivité opposé à celle-ci, les deux portions du substrat formant une jonction P/N (3; 23), en ce que ladite jonction P/N (3; 23) constitue au moins une partie d'une jonction P/N (3; 23, 209b) qui s'étend depuis la face inférieure (104; 204) du substrat (100; 200) jusqu'audit barrage isolant (170; 210), les première (2; 22) et deuxième (1; 21) portions du substrat (100; 200) étant contactées par ladite électrode (13; 25) sur la face inférieure (104; 204) dudit substrat.

2. Dispositif semiconducteur selon la revendication 1, caractérisé en ce que les régions réalisées dans le substrat sont l'émetteur (1) du premier transistor ($T_{E1}$) et une première zone (2) du collecteur (2, 5) du deuxième transistor ($T_{S1}$) tandis que la base (4) du premier transistor et une deuxième zone (5) du collecteur (2, 5) du deuxième transistor sont constituées par des portions de la première couche épitaxiale et que le collecteur (6) du premier transistor et la base (7) du deuxième transistor sont constitués par des portions ($102_a$ et $102_b$) de la deuxième couche épitaxiale (102), l'émetteur (9) du deuxième transistor étant constitué par une zone dopée du premier type de conductivité incluse dans la deuxième couche épitaxiale (102), le contact de base (11) du premier transistor étant constitué par une zone dopée du même premier type de conductivité s'étandant depuis la face supérieure (140) jusqu'à une profondeur supérieure à celle de la deuxième couche épitaxiale (102).

3. Dispositif semiconducteur selon la revendication 1, caractérisé en ce que les régions réalisées dans le substrat (200) sont le collecteur (22) du premier transistor ($T_{s3}$) et une première zone (21) de l'émetteur (21, 26) du deuxième transistor ($T_{e3}$) tandis que la base (27) du premier transistor et une deuxième zone (26) de l'émetteur du deuxième transistor sont constituées par des portions de la première couche épitaxiale (201) et que l'émetteur (28) du premier transistor et la base (29) du deuxième transistor sont constitués par des portions ($202_a$ et $202_b$) de la deuxième couche épitaxiale (202), le collecteur (30) du deuxième transistor étant constitué par une zone dopée de premier type de conductivité incluse dans ladite deuxième couche épitaxiale (202) et la région de contact de base (36) du premier transistor étant constituée par une zone dopée du premier type de conductivité s'étandant depuis la face supérieure (214) jusqu'à une profondeur supérieure à l'épaisseur de la deuxième couche épitaxiale.

4. Dispositif semiconducteur selon la revendication 2 du type amplificateur Darlington mixte, caractérisé en ce que le transistor d'entrée est constitué par ledit premier transistor ($T_{e1}$) et le transistor de sortie par ledit deuxième transistor ($T_{s1}$), le collecteur (6) du premier transistor étant relié à la base (7) du deuxième transistor, une électrode (16) connectée à la base (4) du premier transistor constituant l'entrée de l'amplificateur et les deux régions (1 et 2) créées dans le substrat (100) étant court-circuitées par l'électrode (13) sur la face inférieure (104) du substrat (100) et constituant la sortie.

5. Dispositif semiconducteur selon la revendication 3, du type amplificateur Darlington mixte, caractérisé en ce que le transistor d'entrée ($T_{e3}$) est constitué par ledit deuxième transistor et le transistor de sortie ($T_{s3}$) par ledit premier transistor, le collecteur (30) du deuxième transistor étant relié à la base (27) du premier transistor, une électrode (39) connectée à la base (29) du deuxième transistor constituant l'entrée de l'amplificateur et les deux régions (21 et 22) créées dans le substrat (200) étant court-circuitées par l'électrode (25) sur la face inférieure (204) du substrat (200) et constituant la sortie.

6. Dispositif semiconducteur comportant dans un même corps semiconducteur un premier ensemble Darlington mixte selon la revendication 4 et un deuxième ensemble Darlington mixte selon la revendication 5, caractérisé en ce que les deux portions (521 et 522) de substrat (500), les deux portions (541 et 542) de première couche épitaxiale (540) et les deux portions (551 et 552) de deuxième couche épitaxiale (550) utilisées pour le premier ensemble sont respectivement coplanaires aux deux portions (523 et 524) de substrat (500), aux deux portions (543 et 544) de première couche épitaxiale (540) et aux deux portions (553 et 554) de deuxième couche épitaxiale (550) utilisées pour le deuxième ensemble, en ce que les régions des transistors du premier ensemble créés dans lesdites deux couches épitaxiales sont séparées des régions des transistors du deuxième ensemble créées dans les deux dites couches par un barrage isolant (537) s'étendant depuis la face supérieure (510) jusqu'à une profondeur supérieure à l'épaisseur des deux dites couches épitaxiales, en ce que lesdites quatre portions (521, 522, 523, 524) de substrat (500) sont court-circuitées par l'électrode (505) sur la face inférieure (504) du substrat, et en ce que ces deux ensembles constituent un amplificateur du type dit "push-pull" dont les entrées sont la base (541) du premier transistor ($T_{E1}$) du premier ensemble et la base (553) du deuxième transistor ($T_{F1}$) du deuxième ensemble et dont la sortie est l'électrode (505) située sur la face inférieure (504) du substrat.

7. Dispositif semiconducteur selon l'une des revendications 1 à 6, caractérisé en ce que ladite jonction P/N (3) située entre les deux portions contiguës du substrat (1 et 2) aboutit directement audit barrage isolant (170).

8. Dispositif selon l'une des revendications 1 à 6, caractérisé en ce que ledit barrage isolant (210) touche ledit substrat (200) uniquement dans la portion (22) de celui-ci qui est du deuxième type de conductivité, et en ce que ladite portion (22) du substrat (200) débordant ledit barrage (210) constitue avec l'extrémité voisine de ladite première couche épitaxiale (201) une jonction P/N ($209_b$) qui aboutit à une de ses extrémités audit barrage (210) et qui, à l'autre extrémité, rejoint la jonction P/N (23) située entre les deux portions (21 et 22) de types opposés du substrat (200).

9. Dispositif semiconducteur selon l'une des revendications 1 à 8, caractérisé en ce que ledit barrage isolant (170) consiste principalement en une gorge (17) qui s'enfonce à partir de la surface (140) de la deuxième couche épitaxiale (102) au moins jusqu'au substrat (100).

10. Dispositif selon la revendication 9, caractérisé en ce que ledit barrage (170) est interrompu localement et en ce que le passage (105) ainsi créé supporte une pellicule conductrice (106) qui fait la liaison entre une électrode (14) du premier transistor et une électrode (18) du deuxième transistor.

11. Dispositif selon la revendication 10, caractérisé en ce que la base (7) dudit deuxième transistor ($T_{s1}$) est isolée de la région externe (6) dudit premier transistor ($T_{e1}$) constituée par une portion ($102_a$) de la deuxième couche épitaxiale (102) par une zone (11) de contact de base du premier transistor ($T_{e1}$) homéomorphe à un anneau entourant ladite région externe (6) dudit premier transistor ($T_{e1}$) et s'étendant jusqu'à la première couche épitaxiale (101).

12. Dispositif selon l'une des revendications 10 et 11, caractérisé en ce que, du côté du barrage isolant ($53_a$) opposé à celui dans lequel est créé le premier transistor ($T_{e2}$) un barrage isolant additionnel (54), sensiblement parallèle au premier, sépare un segment (45) étroit et allongé de la première couche épitaxiale (401), et en ce que ledit segment est relié par sa première extrémité ($45_a$) via une zone de liaison du passage (405) à la base (44) du premier transistor ($T_{e2}$) et par sa deuxième extrémité ($45_b$) à la zone (46) de la région externe du deuxième transistor ($T_{s2}$) créée dans ladite première couche épitaxiale (401).

13. Procédé de réalisation d'une dispositif selon l'une des revendications 1 à 12, caractérisé en ce qu'il comporte notamment les opérations suivantes: dans une plaquette (500) d'un type initial de conductivité, des impuretés donnant le type de conductivité opposé au précédent sont introduites localement, au moins dans une certaine épaisseur de substrat, avec une concentration supérieure à celle de ladite plaquette pour créer dans celle-ci au moins une portion (521, 524) du type de conductivité opposé au type initial, puis la première couche épitaxiale (540) faiblement dopée est déposée sur l'une des grandes faces de ladite plaquette sur laquelle affleurent des portions des deux types de conductivité, puis la deuxième couche épitaxiale (550) faiblement dopée du type de conductivité opposé à celui de ladite première couche épitaxiale est déposée sur celle-ci, ensuite des régions localisées sont créées dont au moins deux du type de conductivité de la première couche épitaxiale l'une (561, 564) d'une profondeur supérieure à l'épaisseur de la deuxième couche épitaxiale (550) étant destinée à constituer le contact de base du premier transistor ($T_{E1}$, $T_{T1}$), l'autre (572, 573) destinée à constituer une zone externe du deuxième transistor ($T_{S1}$, $T_{F1}$), étant incluse dans la deuxième couche épitaxiale (550) le barrage isolant (535, 536) est élaboré, les contacts et les connexions sont créés.

14. Procédé selon la revendication 13, caractérisé en ce que, on limite la profondeur des impuretés que l'on introduit à partir d'une première face de ladite plaquette à une valeur inférieure à l'épaisseur de celle-ci, laissant du côté de la deuxième face opposée à la première une couche du type initial de conductivité, puis en ce que, ultérieurement, on élimine, à partir de ladite deuxième face, ladite couche du type initial.

15. Procédé selon la revendication 13, caractérisé en ce que, lesdites impuretés donnant le type de conductivité opposé dans une portion du substrat sont introduites dans celui-ci par thermomigration.

16. Procédé selon la revendication 15, caractérisé en ce que la direction du gradient de température utilisé pour la thermomigration est dans un cône d'axe perpendiculaire aux grandes faces de la plaquette et d'angle au sommet inférieur à 45°.

17. Procédé selon la revendication 13, caractérisé en ce que lesdites impuretés donnant le type de conductivité opposé dans une portion du substrat sont introduites dans celui-ci par diffusion.

18. Procédé selon l'une des revendication 15 et 17, caractérisé en ce que le substrat est du silicium de type N et l'impureté est l'aluminium.

19. Procédé selon les revendications 15, 16 et 18, caractérisé en ce que, on dépose au moins sur une face (502) principale supérieure du substrat (500) une couche de protection (501), en ce que, sur la surface de chaque portion à doper on ouvre dans cette couche de protection au moins une pluralité de fentes ($503_a$, $503_b$, $503_c$ et $503_d$, $503_e$, $503_f$) sensiblement parallèles d'une largeur de 50 $\mu$m à 500 $\mu$m et d'une longueur de 5 à 10 fois leur largeur et distantes les unes des autres de 1 à 50 $\mu$m, lesdites fentes s'étendant sur toute ladite surface de ladite portion et en ce que on crée dans chacune de ces fentes une plage d'aluminium ($506_a$, $506_b$, $506_c$ et $506_d$, $506_e$, $506_f$), puis en ce que on place ladite plaquette dans ledit gradient thermique et en ce que, une fois la migration terminée, on élimine, au moins à partir de ladite face supérieure (502), une couche superificielle, et en ce que sur la nouvelle face (508) ainsi mise à jour, on dépose successivement une première (540), puis une deuxième (550) couche épitaxiale et en ce que on achève ensuite le dispositif.

20. Procédé selon les revendications 15 et 18, caractérisé en ce que, dans le gradient thermique, la température de la face inférieure de la plaquette est comprise entre 1050°C et 1160°C et en ce que la température de la face supérieure lui est inférieure de 5 à 70°C.

21. Procédé selon la revendication 15, caractérisé en ce que le substrat est de type $P^+$ et en ce que les portions $N^+$ sont réalisées par thermomigration d'un alliage d'or-antimoine.

## Patentansprüche

1. Halbleiteranordnung mit einem Halbleiterkörper mit mindestens einem ersten ($T_{e1}$; $T_{s3}$)

und einem zweiten ($T_{s1}$; $T_{e3}$) Transistor, die vertikal, bipolar und komplementär sind, wobei jeder Transistor ein Basisgebiet und zwei externe als Emittergebiet und als Kollektorgebiet dienende Gebiete enthält, wobei der genannte Körper ein Substrat (100; 200) enthält das mit einer ersten epitaktischen Schicht (101; 201) von einem ersten Leitungstyp überzogen ist, auf der sich eine zweite epitaktische Schicht (102; 202) vom zweiten dem ersten entgegengesetzten Leitungstyp erstreckt, wobei das Basisgebiet (4; 27) des ersten Transistors und wenigstens ein Teil (5; 26) eines externen Gebietes des zweiten Transistors durch in derselben Ebene liegende Teile der ersten epitaktischen Schicht gebildet werden, und wobei das Basisgebiet (7; 29) des zweiten Transistors durch einem ersten Teil (102b; 202b) der zweiten epitaktischen Schicht gebildet wird und ein erster Teil (2; 22) des Substrats (100; 200) wenigstens einen Teil des Kollektorgebietes (2,5; 22) eines ($T_{s1}$; $T_{s3}$) des genannten ersten und des genannten zweiten Transistors bildet, während ein isolierender Sperrbereich (170; 210) sich von der oberen Fläche (140; 214) mindestens bis zu dem Substrat (100; 200) erstreckt, welches Substrat durch eine Elektrode (13; 25) auf seiner unteren Fläche (104; 204) kontaktiert wird, dadurch gekennzeichnet, dass mindestens ein Teil (6; 28) eines externen Gebietes des ersten Transistors durch einen zweiten Teil (102a; 202a) der zweiten epitaktischen Schicht gebildet wird, der mit dem ersten Teil der genannten Schicht in einer Ebene liegt, dass mindestens ein Teil des Emittergebietes (1; 21) eines Transistors ($T_{e1}$; $T_{e3}$) durch einen zweiten Teil (1; 21) des Substrats (100; 200) gebildet wird, der an den ersten Teil (2;22) des Substrats grenzt und mit diesem Teil in einer Ebene liegt und einen dem dieses ersten Teiles entgegengesetzten Leitungstyp aufweist, wobei die zwei Teile des Substrats einen P N-Ubergang (3; 23) bilden, dass der genannte P N-Ubergang (3; 23) mindestens einen Teil eines P N-Ubergangs (3; 23, 209b) bildet, der sich von der unteren Fläche (104; 204) des Substrats (100; 200) her bis zum genannten isolierenden Sperrbereich (170; 210) erstreckt, wobei der erste (2; 22) und der zweite (1; 21) Teil des Substrats (100; 200) durch die genannte Elektrode (13; 25) auf der unteren Fläche (104; 204) des genannten Substrats kontaktiert werden.

2. Halbleiteranordnung nach Anspruch 1, dadurch gekennzeichnet, dass die genannten in dem Substrat erzeugten Gebiete das Emittergebiet (1) des ersten Transistors ($T_{e1}$ und eine erste Zone (2) des Kollektorgebietes (2, 5) des zweiten Transistors ($T_{s1}$) sind, während das Basisgebiet (4) des ersten Transistors und eine zweite Zone (5) des Kollektorgebietes (2, 5) des zweiten Transistors durch Teile der ersten epitaktischen Schicht gebildet werden, und dass das Kollektorgebiet (6) des ersten Transistors und das Basisgebiet (7) des zweiten Transistors durch Teile (102a und 102b) der zweiten epitaktischen Schicht (102) gebildet werden, wobei das Emittergebiet (9) des zweiten Transistors durch eine dotierte Zone vom ersten Leitungstyp gebildet wird, die in die zweite epitaktische Schicht (102) aufgenommen ist, und wobei der Basiskontakt (11) des ersten Transistors durch eine dotierte Zone vom gleichen ersten Leitungstyp gebildet wird, die sich von der oberen Fläche (140) bis zu einer die Dicke der zweiten epitaktischen Schicht (102) überschreitenden Tiefe erstreckt.

3. Halbleiteranordnung nach Anspruch 1, dadurch gekennzeichnet, dass die in dem Substrat (200) erzeugten Gebiete das Kollektorgebiet (22) des ersten Transistors ($T_{s3}$) und eine erste Zone (21) des Emittergebietes (21, 26) des zweiten Transistors ($T_{e3}$) sind, während des Basisgebiet (27) des ersten Transistors und eine zweite Zone (26) des Emittergebietes des zweiten Transistors durch Teile der ersten epitaktischen Schicht (201) gebildet werden, und dass das Emittergebiet (28) des ersten Transistors und das Basisgebiet (29) des zweiten epitaktischen Schicht (202) gebildet werden, wobei das Kollektorgebiet (30) des zweiten Transistors durch eine dotierte Zone vom ersten Leitungstyp gebildet wird, die in die genannte zweite epitaktische Schicht (202) aufgenommen ist, und wobei das Basiskontaktgebiet (36) des ersten Transistors durch eine dotierte Zone vom ersten Leitungstyp gebildet wird, die sich von der oberen Fläche (214) bis zu einer die Dicke der zweiten epitaktischen Schicht überschreitenden Tiefe erstreckt.

4. Halbleiteranordnung nach Anspruch 2 vom gemischten Darlingtonverstärkertyp, dadurch gekennzeichnet, dass der Eingangstransistor durch den genannten ersten Transistor ($T_{e1}$ und der Ausgangstransistor durch den genannten zweiten Transistor ($T_{s1}$) gebildet wird, wobei das Kollektorgebiet (6) des ersten Transistors mit dem Basisgebiet (7) des zweiten Transistors verbunden ist, und wobei eine Elektrode (16), die mit dem Basisgebiet (4) des ersten Transistors verbunden ist, den Eingang des Verstärkers bildet, während die zwei im Substrat (100) erzeugten Gebiete (1 und 2) durch die Elektrode (13) auf der unteren Fläche (104) des Substrat (100) kurzgeschlossen werden und den Ausgang bilden.

5. Halbleiteranordnung nach Anspruch 3 vom gemischten Darlingtonverstärkertyp, dadurch gekennzeichnet, dass der Eingangstransistor ($T_{e3}$) durch den genannten zweiten Transistor und der Ausgangstransistor ($T_{s3}$) durch den genannten ersten Transistor gebildet wird, wobei das Kollektorgebiet (30) des zweiten Transistors mit dem Basisgebiet (27) des ersten Transistors verbunden ist, und wobei eine Elektrode (39), die mit dem Basisgebiet (29) des zweiten Transistors verbunden ist, den Eingang des Verstärkers bildet, während die zwei im Substrat (200) erzeugten Gebiete (21 und 22) durch die Elektrode (25) auf der unteren Fläche (204) des Substrats (200) kurzgeschlossen werden und den Ausgang bilden.

6. Halbleiteranordnung, die in demselben Halbleiterkörper ein erstes gemischtes Darlingtongebilde nach Anspruch 4 und ein zweites gemischtes Darlingtongebilde nach Anspruch 5 enthält, dadurch gekennzeichnet, dass die zwei Teile (521 und 522) des Substrats (500), die zwei Teile (541 und 542) der ersten epitaktischen Schicht (540) und die zwei Teile (551 und 552) der zweiten epitaktischen Schicht (550), die für das erste Gebilde verwendet werden, mit den zwei Teilen (523 und 524) des Substrats (500), mit den zwei Teilen (543 und 544) der ersten epitaktischen Schicht (540) bzw. mit den zwei Teilen (553 und 554) der zweiten epitaktischen Schicht (550), die für das zweite Gebilde verwendet werden, in einer Ebene liegen, dass die Gebiete der Transistoren des ersten Gebildes, die in den genannten zwei epitaktischen Schichten erzeugt werden, von den Gebieten der Transistoren des zweiten Gebildes, die in den zwei genannten Schichten erzeugt werden, durch einen isolierenden Sperrbereich (537) getrennt werden, die sich von der oberen Fläche (510) bis zu einer die Dicke der zwei genannten epitaktischen Schichten überschreitenden Tiefe erstreckt, dass die genannten vier Teile (521, 522, 523, 524) des Substrats (500) durch die Elektrode (505) auf der unteren Fläche (504) des Substrats kurzgeschlossen werden, und das diese zwei Gebilde einen Verstärker vom sogenannten "Pushpull"-Typ bilden, dessen Eingänge durch das Basis gebiet (541) desersten Transistors (T$_{e1}$) des ersten Gebildes und das Basisgebiet (553) des zweiten Transistors (T$_{f1}$) des zweiten Gebildes gebildet werden und dessen Ausgang durch die Elektrode (505) gebildet wird, die sich auf der unteren Fläche (504) des Substrats befindet.

7. Halbleiteranordnung nach einem der Ansprüche 1 bis 6, dadurch gekennzeichnet, dass der genannte P/N-Übergang (3), der sich zwischen den zwei benachbarten Teilen des Substrats (1 und 2) befindet, direkt an den genannten isolierenden Sperrbereich (170) grenzt.

8. Anordnung nach einem der Ansprüche 1 bis 6, dadurch gekennzeichnet, dass der genannte isolierende Sperrbereich (210) das genannte Substrat (200) lediglich in dem Teil (22) desselben berührt, der den zweiten Leitungstyp aufweist, und dass der genannte Teil (22) des Substrats (200), der an den genannten Sperrbereich (210) grenzt, mit dem benachbarten Ende der genannten ersten epitaktischen Schicht (201) einen P N-Übergang (209b) bildet, der mit einem seiner Enden an den genannten Sperrbereich (210) grenzt und sich mit dem anderen Ende an den P N-Übergang (23) anschliesst, der sich zwischen den zwei Teilen (21 und 22) entgegengesetzter Leitungstypen des Substrats (200) befindet.

9. Halbleiteranordnung nach einem der Ansprüche 1 bis 8, dadurch gekennzeichnet, dass der genannte isolierende Sperrbereich (170) im wesentlichen aus einer Nut (17) besteht, der sich von der Oberfläche (140) der zweiten epitaktischen Schicht (102) wenigstens bis zu dem Substrat (100) erstreckt.

10. Anordnung nach Anspruch 9, dadurch gekennzeichnet, dass der genannte Sperrbereich (170) örtlich unterbrochen ist, und dass der so gebildete Durchgang (105) eine leitende Schicht (106) trägt, die die Verbindung zwischen einer Elektrode (14) des ersten Transistors und einer Elektrode (18) des zweiten Transistors herstellt.

11. Anordnung nach Anspruch 10, dadurch gekennzeichnet, dass das Basisgebiet (7) des genannten zweiten Transistors (T$_{s1}$) gegen das externe Gebiet (6) des genannten ersten Transistors (T$_{e1}$), das durch einen Teil (102a) der zweiten epitaktischen Schicht (102) gebildet wird, durch eine Basiskontaktzone 11 des ersten Transistors (T$_{e1}$) isoliert ist, die die Form eines das genannte externe Gebiet (6) des genannten ersten Transistors (T$_{e1}$) umgebenden Ringes aufweist und sich bis zu der ersten epitaktischen Schicht (101) erstreckt.

12. Anordnung nach einem der Ansprüche 10 und 11, dadurch gekennzeichnet, dass auf der Seite des isolierenden Sperrbereiches (53a), der der Seite gegenüber liegt, in der der erste Transistor (T$_{e2}$) gebildet wird, ein zusätzlicher isolierender Sperrbereich (54), der zu der ersten nahezu parallel ist, ein schmales und langgestrecktes Segment (45) von der ersten epitaktischen Schicht (401) trennt, und dass das genannte Segment über sein erstes Ende (45a) durch eine Verbindungszone des Durchgangs (405) mit dem Basisgebiet (44) des ersten Transistors (T$_{e2}$) und über sein zweites Ende (45b) mit der Zone (46) des externen Gebietes des zweiten Transistors (T$_{s2}$) verbunden ist, die in der genannten ersten epitaktischen Schicht (401) gebildet ist.

13. Verfahren zur Herstellung einer Anordnung nach einem der Ansprüche 1 bis 12, dadurch gekennzeichnet, dass es folgende Schritte umfast: in eine Scheibe (500) von einem ersten Leitungstyp werden Dotierungsstoffe die den dem vorhergehenden Leitungstyp entgegengesetzten Leitungstyp herbeiführen, örtlich wenigstens über einen gewissen Teil der Dicke des Substrats mit einer die der genannten Scheibe überschreitenden Konzentration eingeführt, um darin mindestens einen Teil (521, 524) vom dem ersten Typ entgegengesetzten Leitungstyp zu bilden; dann wird die erste epitaktische Schicht (540), die schwach dotiert ist, auf einer der grossen Flächen der genannten Scheibe abgelagert, an der Teile der beiden Leitungstypen grenzen; dann wird die zweite epitaktische Schicht (550), die schwach dotiert ist und den dem der genannten ersten epitaktischen Schicht entgegengesetzten Leitungstyp aufweist, auf dieser Schicht abgelagert; dann werden lokalisierte Gebiete erzeugt, von denen mindestens zwei den Leitungstyp der ersten epitaktischen Schicht aufweisen, wobei eines (561, 564) mit einer die Dicke der zweiten epitaktischen Schicht (550) überschreitenden Tiefe für die Bildung des Basiskontakts des ersten Transistors ($T_{e1}$, $T_{t1}$) bestimmt und das andere (572, 573) für die Bildung einer externen Zone des zweiten Transistors ($T_{s1}$, $T_{f1}$) bestimmt und in die zweite epitaktische Schicht (550) aufgenommen ist; der isolierende Sperrbereich (535, 536) wird angebracht und die Kontakte und die Anschlüsse werden gebildet.

14. Verfahren nach Anspruch 13, dadurch gekennzeichnet, dass die Eindringtiefe der Dotierungsstoffe die von einer ersten Fläche der genannten Scheibe her eingeführt werden, auf einen Wert beschränkt wird, der kleiner als die Dicke dieser Scheibe ist, wobei auf der Seite der zweiten Fläche, die der ersten Fläche gegenüber liegt, eine Schicht vom ersten Leitungstyp zurückbleibt; und dass nachher von der genannten zweiten Fläche her die genannte Schicht vom ersten Leitungstyp entfernt wird.

15. Verfahren nach Anspruch 13, dadurch gekennzeichnet, dass die genannten Dotierungsstoffe, die in einem Teil des Substrats den entgegengesetzten Leitungstyp herbeiführen, in das Substrat durch thermische Wanderung eingeführt werden.

16. Verfahren nach Anspruch 15, dadurch gekennzeichnet, dass die Richtung des für die thermische Wanderung angewandten Temperaturgradienten gemäss einem Kegel verläuft, dessen Achse zu den grossen Flächen der Scheibe senkrecht ist und dessen Scheitelwinkel weniger als 45° ist.

17. Verfahren nach Anspruch 13, dadurch gekennzeichnet, dass die genannten Dotierungsstoffe, die in einem Teil des Substrats den entgegengesetzten Leitungstyp herbeiführen, in dieses Substrat durch Diffusion eingeführt werden.

18. Verfahren nach einem der Ansprüche 15 und 17, dadurch gekennzeichnet, dass das Substrat aus n-leitendem Silicium besteht und die Verunreinigung Aluminium ist.

19. Verfahren nach den Ansprüchen 15, 16 und 18, dadurch gekennzeichnet, dass wenigstens auf einer oberen Hauptfläche (502) des Substrats (500) eine Schutzschicht (501) abgelagert wird, dass auf der Oberfläche jedes zu dotierenden Teiles in dieser Schutzschicht wenigstens eine Anzahl von Spalten (503a, 503b, 503c und 503d, 503e, 503f) vorgesehen werden, die zueinander nahezu parallel sind und eine Breite von 50 $\mu$m bis 500 $\mu$m und eine Länge gleich dem Zehnfachen ihrer Breite aufweisen und in gegenseitigen Abständen von 1 bis 50 $\mu$m liegen, wobei die genannten Spalten sich über die ganze genannte Oberfläche des genannten Teiles erstrecken, und dass in jedem dieser Spalte eine Aluminiumfläche (506a, 506b, 506c und 506d, 506e, 506f) gebildet wird, wonach die genannte Scheibe in dem genannten Temperaturgradienten angebracht und nach Beendigung der thermischen Wanderung wenigstens von der genannten oberen Fläche (502) her eine Oberflächenschicht beseitigt wird, wobei auf der so erhaltenen neuen Fläche (508) nacheinander eine erste (540) und dann eine zweite (550) epitaktische Schicht abgelagert werden, wonach die Anordnung fertiggestellt wird.

20. Verfahren nach den Ansprüchen 15 und 18, dadurch gekennzeichnet, dass in dem Temperaturgradienten die Temperatur der unteren Fläche der Scheibe zwischen 1050°C und 1160°C liegt, und dass die Temperatur der oberen Fläche ihrerseits 5 bis 70°C niedriger ist.

21. Verfahren nach Anspruch 15, dadurch gekennzeichnet, dass das Substrat vom P$^+$-Typ ist, und dass die N$^+$-leitenden Teile durch thermische Wanderung einer Gold-Antimon-Legierung gebildet werden.

**Claims**

1. A semiconductor device comprising a semiconductor body having at least a first ($T_{e1}$, $T_{s3}$) and a second ($T_{s1}$; $T_{e3}$) bipolar and complementary vertical transistor, each transistor comprising a base region between two external regions serving as emitter region and collector region, the said body being constituted by a substrate (100; 200) covered by a first epitaxial layer (101; 201) of a first conductivity type on which extends a second epitaxial layer (102; 202) of the second conductivity type opposite to the first, the base region (4; 27) of the first transistor and at least a part (5; 26) of an external region of the second transistor being formed by coplanar portions of the first epitaxial layer, the base region (7, 29) of the second transistor being formed by a first portion (102b; 202b) of the second epitaxial layer and a first portion (2, 22) of the substrate (100, 200) constituting at least a part of the collector region (2, 5, 22) of one ($T_{s1}$; $T_{s3}$) of the first and second transistors, an isolating barrier (170, 210) extending from the upper surface (140; 214) down to at least the substrate (100; 200) which is contacted by an electrode (13, 25) on its lower surface (104, 204) characterized in that at least a part (6, 28) of an external region of the first transistor is formed by a second portion (102a, 202a) of the second epitaxial layer, coplanar with the first portion of the said layer, that at least a part of the emitter region (1; 21) of one transistor ($T_{e1}$; $T_{e3}$) is constituted by a second portion (1; 21) of the substrate (100; 200) adjacent to and coplanar with the first portion (2; 22) of the substrate and of a conductivity type opposite thereto, the two portions of the substrate forming a p-n junction (3; 23), that the said p-n junction (3; 23) constitutes at least a part of a p-n junction (3; 23, 209b) which extends from the lower face (104, 204) of the substrate (100; 200) up to the isolating barrier (170; 210), the first (2; 22) and second (1; 21) portions of the substrate (100; 200) being contacted by the said electrode (13; 25) on the lower face (104; 204) of the said substrate.

2. A semiconductor device as claimed in Claim 1, characterized in that the regions made in the substrate are the emitter (1) of the first transistor $(T_{e1})$ and a first zone (2) of the collector (2, 5) of the second transistor $(T_{s1})$, while the base (4) of the first transistor and a second zone (5) of the collector (2, 5) of the second transistor are constituted by portions of the first epitaxial layer, and that the collector (6) of the first transistor and the base (7) of the second transistor are constituted by portions 102a and 102b) of the second epitaxial layer (102), the emitter (9) of the second transistor being constituted by a doped zone of the first conductivity type included in the second epitaxial layer (102), the base contact (11) of the first transistor being constituted by a doped zone of the same first conductivity type extending from the upper surface (140) down to a depth exceeding that of the second epitaxial layer (102).

3. A semiconductor device as claimed in Claim 1, characterized in that the regions made in the substrate (200) are the collector (22) of the first transistor $(T_{s3})$ and a first zone (21) of the emitter (21, 26) of the second transistor $(T_{e3})$, while the base (27) of the first transistor and a second zone (26) of the emitter of the second transistor are constituted by portions of the first epitaxial layer (201), and that the emitter (28) of the first transistor and the base (29) of the second transistor are constituted by portions 202a and 202b) of the second epitaxial layer (202), the collector (30) of the second transistor being constituted by a doped zone of the first conductivity type included in the said second epitaxial layer (202) and the base contact region (36) of the first transistor being constituted by a doped zone of the first conductivity type extending from the upper face (214) down to a depth exceeding the thickness of the second epitaxial layer.

4. A semiconductor device as claimed in Claim 2 of the mixed Darlington amplifier type, characterized in that the input transistor is constituted by the said first transistor $(T_{e1})$ and the output transistor by the said second transistor $(T_{s1})$, the collector (6) of the first transistor being connected to the base (7) of the second transistor, an electrode (16) connected to the base (4) of the first transistor constituting the input of the amplifier and the two regions (1 and 2) made in the substrate (100) being short-circuited by the electrode (13) on the lower face (104) of the substrate (100) and constituting the output.

5. A semiconductor device as claimed in Claim 3 of the mixed Darlington amplifier type, characterized in that the input transistor $(T_{e3})$ is constituted by the said second transistor and the output transistor $(T_{s3})$ by the said first transistor, the collector (30) of the second transistor being connected to the base (27) of the first transistor, an electrode (39) connected to the base (29) of the second transistor constituting the input of the amplifier and the two regions (21 and 22) made in the substrate (200) being short-circuited by the electrode (25) on the lower face (204) of the substrate (200) and constituting the output.

6. A semiconductor device comprising in a same semiconductor body a first mixed Darlington assembly as claimed in Claim 4 and a second mixed Darlington assembly as claimed in Claim 5, characterized in that the two substrate (500) portions (521 and 522), the two portions (541 and 542) of the first epitaxial layer (540) and the two portions (551 and 552) of the second epitaxial layer (550) used for the first assembly are respectively coplanar to the two portions (523 and 524) of the substrate (500), to the two portions (543 and 544) of the first epitaxial layer (540) and to the two portions (553 and 554) of the second epitaxial layer (550) used for the second assembly, that the regions of the transistors of the first assembly made in the said two epitaxial layers are separated from the regions of the transistors of the second assembly made in the two said layers by an isolating barrier (537) extending from the upper face (510) down to a depth exceeding the thickness of the two said epitaxial layers, that the said four portions (521, 522, 523, 524) of the substrate (500) are short-circuited by the electrode (505) on the lower face (504) of the substrate, and that said two assemblies constitute an amplifier of the so-called push-pull type of which the inputs are the base (541) of the first transistor $(T_{e1})$ of the first assembly and the base (553) of the second transistor $(T_{f1})$ of the second assembly and of which the output is the electrode (505) situated on the lower face (504) of the substrate.

7. A semiconductor device as claimed in any of Claims 1 to 6, characterized in that the said p-n junction (3) situated between the two adjoining portions of the substrate (1 and 2) directly terminate at the said isolating barrier (170).

8. A device as claimed in any of the Claims 1 to 6, characterized in that the said isolating barrier (210) touches the said substrate (200) only in the portion (22) thereof which is of the second conductivity type, and that the said portion (22) of the substrate (200) projecting from the said barrier (210) constitutes with the adjacent extremity of the said first epitaxial layer (201) a *p-n* junction (209b) which terminates at one of its extremities at the said barrier (210) and which, at the other extremity, rejoins the *p-n* junction (23) situated between the two portions (21 and 22) of opposite types of the substrate (200).

9. A semiconductor device as claimed in any of the Claims 1 to 8, characterized in that the isolating barrier (170) consists substantially of a groove (17) which penetrates from the surface (140) of the second epitaxial layer (102) at least down to the substrate (100).

10. A device as claimed in Claim 9, characterized in that the said barrier (170) is locally interrupted and in that the passage (105) thus formed supports a conductive layer (106) which forms the connection between an electrode (14) of the first transistor and an electrode (18) of the second transistor.

11. A device as claimed in Claim 10, characterised in that the base (7) of the said second transistor $(T_{s1})$ is separated from the external region (6) of the said first transistor $(T_{e1})$ constituted by a portion (102a) of the second epitaxial layer (102) by a base contact zone (11) of the first transistor $(T_{e1})$ which is homeomorphous to a ring surrounding the said external region (6) of the said first transistor $(T_{e1})$ and extending up to the first epitaxial layer (101).

12. A device as claimed in any of the Claims 10 and 11, characterized in that, on the side of the isolating barrier (53a) opposite to that in which the first transistor $(T_{e2})$ is formed, an additional isolating barrier (54) substantially parallel to the first separates a narrow and elongate segment (45) from the first epitaxial layer (401), and that the said segment is connected by its first extremity (45a) *via* a connection zone of the passage (405) to the base (44) of the first transistor $(T_{e2})$ and by its second extremity (45b) to the zone (46) of the external region of the second transistor $(T_{s2})$ formed in the said first epitaxial layer (401).

13. A method of manufacturing a device as claimed in any of the Claims 1 to 12, characterized in that it comprises notably the following operations: in a plate (500) of first conductivity type impurities giving the conductivity type opposite to the preceding are introduced locally at least in a certain thickness of the substrate, in a concentration exceeding that of the said plate to form therein at least a portion (521, 526) of the type opposite to the first conductivity type, the low-doped first epitaxial layer (540) is then deposited on one of the major faces of the said plate on which portions of the two conductivity types will grow, then the second low-doped epitaxial layer (550) of the conductivity type opposite to that of the said first epitaxial layer is deposited thereon, then localized regions are formed of which at least two of the conductivity type of the first epitaxial layer, one (561, 564) having a depth exceeding the thickness of the second epitaxial layer (550) being destined to constitute the base contact of the first transistor $(T_{e1}, T_{T1})$, the other (572, 573) destined to constitute an external zone of the second transistor $(T_{s1}, T_{F1})$ being included in the second epitaxial layer (550), the isolating barrier (535, 536) is provided and the contacts and the connections are made.

14. A method as claimed in Claim 13, characterized in that the depth of the inpurities which are introduced from a first face of the said plate are limited to a value lower than the thickness thereof, leaving on the side of the second face opposite to the first a layer of the initial conductivity type, then, finally, the said layer of the first type is removed from the second face.

15. A method as claimed in Claim 13, characterized in that the said impurities giving the opposite conductivity type in a portion of the substrate are introduced therein by thermomigration.

16. A method as claimed in Claim 15, characterized in that the direction of the temperature gradient used for the thermomigration is in a cone having an axis perpendicular to the large faces of the plate and a top angle smaller than 45°.

17. A method as claimed in Claim 13, characterized in that the said impurities giving the opposite conductivity type in a portion of the substrate are introduced therein by diffusion.

18. A method as claimed in any of the Claims 15 and 17, characterized in that the substrate is N-type silicon and the impurity is aluminium.

19. A method as claimed in Claims 15, 16 and 18, characterized in that a protective layer (501) is deposited at least on an upper principal face (502) of the substrate (500), that, on the surface of each portion to be doped, at least a plurality of slots (503a, 503b, 503c, and 503d, 503e, 503f) are opened in said protective layer and are substantially parallel having a width of 50 $\mu$m to 500 $\mu$m and a length of 5 to 10 times their width and separated from each other by 1 to 50 $\mu$m, the said slots extending on the whole of the said surface of the said portion, and that in each of said slots an aluminium area (506a, 506b, 506c and 506d, 506e, 506f) is formed, that the said plate is then placed in the said thermal gradient and that, once the migration is terminated, at least a surface layer is removed from the said upper surface (502), and that the new face (508) thus formed a first (540) and then a second (550) epitaxial layer are successively deposited, after which the remaining process steps are carried out.

20. A method as claimed in Claims 15 and 18, characterized in that the thermal gradient the temperature of the lower face of the plate lies between 1050°C and 1160°C and that the temperature of the upper face is 5° to 70°C lower.

21. A method as claimed in Claim 15, characterized in that the substrate is of the $P^+$ type and that the $N^+$ portions are made by thermomigration of a gold-antimony alloy.

# 0 002 087

FIG.1

FIG.2

FIG.3

$T_{e1}$      $T_{s1}$

FIG.5

$T_{e1}$      $T_{s1}$

FIG.4

0 002 087

FIG. 6

FIG.7

FIG.8

FIG.10

FIG.9

$T_{e3}$     $T_{s3}$

503a 503b 503c 503d 503e 503f
501a 501b 501c 501d 501e 501f 501g 502
501

500

504 501

**FIG.11A**

501 506

500

501

**FIG.11B**

506a 506b 506c 506d 506e 506f 506g
501

500

501

**FIG.11C**

507a 507b 507c 507d 507e 507f 507g
501

501
525 509a 509b 522 509c 509d 523

**FIG.11D**

508

525 522 523

**FIG.11E**

FIG.11 F

FIG.11G

FIG.11 H

FIG.11 I

FIG.12 A

FIG.12 B

FIG.12 C

FIG.12 D

8

0 002 087

FIG.12 E

FIG.12 F

FIG.12 G

FIG.12 H

$T_{E2}$  $T_{S2}$  $T_{F2}$  $T_{T2}$

9